# EUROPEAN PATENT APPLICATION

(11) **EP 1 677 409 A2**
(43) Date of publication of application: **05.07.2006**
(21) Application number: 05028405.8
(22) Date of filing: 23.12.2005
(51) Int. Cl.: H02K 21/16, H02K 5/22

(54) **Electric power steering system using wound lead storage battery as power supply, and motor and inverter used in same**

(30) Priority: 28.12.2004 JP 2004378582
(71) Applicant: Hitachi, Ltd., Tokyo (JP)
(72) Inventor: Honbo, Kyoko, Hitachi, Ltd., Int. Prop. Grou, Chiyoda-ku Tokyo 100-8220 (JP); Sakai, Masanori, Hitachi, Ltd., Int. Prop. Grou, Chiyoda-ku Tokyo 100-8220 (JP); Innami, Toshiyuki, Hitachi, Ltd., Int. Prop. Grou, Chiyoda-ku Tokyo 100-8220 (JP); Mirumachi, Mitsuaki, Hitachi, Ltd., Int. Prop. Gr., Chiyoda-ku Tokyo 100-8220 (JP); Sasaki, Shoji, Hitachi, Ltd., Int. Prop. Grou, Chiyoda-ku Tokyo 100-8220 (JP); Kitamura, Masashi, Hitachi, Ltd., Int. Prop. Group, Chiyoda-ku Tokyo 100-8220 (JP); Tajima, Fumio, Hitachi, Ltd., Int. Prop. Group, Chiyoda-ku Tokyo 100-8220 (JP); Shirakawa, Shinji, Hitachi, Ltd., Int. Prop. Group, Chiyoda-ku Tokyo 100-8220 (JP)
(74) Representative: Beetz & Partner

(57) **Abstract**

The invention relates to an electric power steering system having high performance and high reliability. The electric power steering system employs, as a power supply, a wound lead storage battery (300) in which a thin band-shaped positive plate (21), a thin band-shaped negative plate (20), and a band-shaped separator (22) interposed between the positive and negative plates (21, 20) are wound to form a plate group and the plate group is immersed in an electrolyte. In a motor (100) used for electric power steering, a plate-shaped conductor (116) is employed as a connecting ring for electrical connection between a cable (162) for introducing multi-phase AC power to stator coils (114) and the stator coils (114).

## Description

### BACKGROUND OF THE INVENTION

### 1. Field of the Invention

The present invention relates to an electric power steering system using a wound lead storage battery as a power supply, and also relates to a motor and an inverter used in the electric power steering system.

### 2. Description of the Related Art

As the background art related to electric power steering systems, there are known techniques disclosed in, e.g., JP-A-2001-275325, JP-A-2003-250254 or JP-A-2003-267233. JP-A-2001-275325 and JP-A-2003-250254 disclose electric power steering motors driven by 3-phase AC power. JP-A-2003-267233 discloses an electric power steering system comprising a motor driven by 3-phase AC power and a control unit for controlling the motor.

Also, the background art related to wound lead storage batteries is disclosed in, e.g., JP-A-2004-178831 or JP-A-2004-207127.

### SUMMARY OF THE INVENTION

In recent years, an AC-driven electric power steering system has been prevalently employed. In such a system, a lead storage battery constituting a 14V onboard power supply system is used as a power supply, and DC power produced by the power supply is converted to AC power by an inverter. An AC motor is driven by the AC power to obtain electromotive forces for steering.

On the other hand, the electric power steering system is required to have a higher output to be adapted for a wide range of vehicles from light- to heavy-duty vehicles. Hitherto, it has been usual that a power steering system of the type directly outputting steering forces from a motor is used in a relatively small light-duty vehicle, and a power steering system of the hydraulically assisted type is used in a relatively large heavy-duty vehicle. However, the hydraulically assisted type has a large-sized and complicated structure, and is more expensive than the type directly outputting steering forces from a motor. For that reason, there is a demand for the electric power steering system to produce such a high output as enabling the motor to directly output steering forces equivalent or close to those produced by the known hydraulically assisted type.

However, electric power necessary for enabling the motor to directly output steering forces equivalent or close to those produced by the known hydraulically assisted type cannot be obtained with an electric power steering system using, as a power supply, a lead storage battery generally mounted on an automobile, i.e., the lead storage battery constituting the 14V onboard power supply system, from the specific capability of the lead storage battery. Such a lead storage battery has a structure in which a plate group is constituted as a horizontally stacked assembly of positive plates, negative plates and separators interposed between those plates, and the plate group is immersed in an electrolyte. Stated another way, the capacity of the power supply must be increased in order to produce a demanded high output.

Also, when a steering wheel is operated while a vehicle is stopped or while the vehicle is running at a very low speed, the electric power steering system is required to produce a relatively large steering force. At this time, a large current flows momentarily through the electric power steering system.

In the electric power steering system using the above-described lead storage battery as the power supply, however, if the current flowing momentarily becomes too large, the capacity of the lead storage battery is reduced below that resulting in the running state of the vehicle. Accordingly, the power obtained from the power supply is reduced and the steering force outputted from the motor becomes lower than the required steering force. For that reason, the capacity of the power supply must be increased in order to output the required steering force even in the case where a large current flows momentarily.

Meanwhile, in the electric power steering system, currents flowing through the motor and an inverter are increased with an increase in the capacity of the power supply to such an extent as exceeding those flowing through the motor and the inverter when the above-described lead storage battery is used as the power supply. With an increase in the capacity of the power supply, therefore, the electric power steering system is required to modify the structures of the motor and the inverter to be adapted for larger currents.

One object of the present invention is to provide an electric power steering system in which, even when a large current flows momentarily from the power supply side to the actuator side, driving power can be stably supplied from the power supply side to the actuator side, thereby suppressing not only a drop of a system output, but also a deterioration of reliability in actuator operation even with a large current flowing momentarily from the power supply side to the actuator side.

Another object of the present invention is to provide an electric power steering system, which can realize a higher system output and can suppress a deterioration of reliability in the actuator operation in spite of an increase of current caused by the higher output.

Still another object of the present invention is to provide a motor for electric power steering, which can hold a loss small and efficiently output a large steering force even when a wound lead storage battery capable of generating a high output is used as a power supply of the electric power steering system and a large current is supplied from the power supply side to the actuator side of the electric power steering system.

Still another object of the present invention is to provide an inverter for electric power steering, which can ensure reliability in an electrically connected portion between conductors even when a wound lead storage battery capable of generating a high output is used as a power supply of the electric power steering system and a large current is supplied from the power supply side to the actuator side of the electric power steering system.

To achieve the above objects, the present invention is featured in using a wound lead storage battery, described below, as the power supply of the electric power steering system, and/or using a motor or an inverter, described below, as the motor or the inverter for the electric power steering.

In the wound lead storage battery, a thin band-shaped positive plate, a thin band-shaped negative plate, and/or a band-shaped separator interposed between the positive and negative plates are wound to form a plate group. The plate group may be immersed in an electrolyte. An area of the positive plate constituting the plate group is 1500 - 15000 cm². Also, a positive plate area per unit volume is 1700 - 17000 cm²/dm³ when maximum outer dimensions of the battery are estimated on an assumption of the battery being parallelepiped. The wound lead storage battery is able to output a voltage larger than 12 V even when a current of at least 100 A is momentarily outputted to the actuator side (i.e., the motor and inverter side) in the electric power steering system.

In the motor, the stator coils are made up of a plurality of phase windings formed by winding a plurality of wires. The plurality of phase windings have wire ends which are projected axially outward from one axial end of the stator core and are electrically connected by connecting members per phase. The connecting members are formed of plate-shaped conductors for electrically connecting the plurality of phase windings per phase. The stator coils are electrically connected to a cable for introducing the multi-phase AC power to the stator coils, whereby the multi-phase AC power introduced through the cable is supplied to the corresponding phase windings of the stator coils.

In another motor, the stator coils are constituted by electrically connecting a plurality of phase winding groups in delta connection, which are each obtained by electrically connecting the plurality of phase windings per phase. This arrangement may be combined with the above-mentioned motor.

The inverter includes a conductor module electrically connected to a power module. The conductor module includes a plate-shaped conductor electrically connected to a conversion circuit made up of semiconductor switching devices. The plate-shaped conductor forms a circuit for introducing DC power supplied from the power supply side to the conversion circuit. Circuit parts including at least a filter and a capacitor are electrically connected to the plate-shaped conductor. The circuit parts are provided with terminals for connection to the plate-shaped conductor. The terminals of the circuit parts are joined to the plate-shaped conductor by welding.

According to the present invention mentioned above, even when a large current flows momentarily from the power supply side to the actuator side, driving power can be stably supplied from the power supply side to the actuator side, thereby suppressing not only a drop of a system output, but also a deterioration of reliability in the actuator operation even with a large current flowing momentarily from the power supply side to the actuator side. Therefore, an electric power steering system having high performance and high reliability can be obtained.

Also, according to the present invention, it is possible to realize a higher system output and to suppress a deterioration of reliability in the actuator operation in spite of an increase of current caused by the higher output. Therefore, an electric power steering system having high performance and high reliability can be obtained.

Further, according to the present invention, a loss can be held small and a large steering force can be efficiently outputted even when a wound lead storage battery capable of generating a high output is used as a power supply of the electric power steering system and a large current is supplied from the power supply side to the actuator side of the electric power steering system. Therefore, a high-output and highly reliable motor can be obtained which is suitable for the electric power steering system.

In addition, according to the present invention, reliability in an electrically connected portion between conductors can be ensured even when a wound lead storage battery capable of generating a high output is used as a power supply of the electric power steering system and a large current is supplied from the power supply side to the actuator side of the electric power steering system. Therefore, a high-output and highly reliable inverter can be obtained which is suitable for the electric power steering system.
The above features of the invention may be combined in any way in part or as a whole.

### BRIEF DESCRIPTION OF THE DRAWINGS

Fig. 1 is a partial sectional view showing the internal structure of a single cell of a lead storage battery used as a power supply of an electric power steering system according to an embodiment of the present invention;
Fig. 2 is a perspective view showing the external appearance of the lead storage battery loaded with the columnar single cell shown in Fig. 1;
Fig. 3 is a perspective view showing the external appearance of the lead storage battery loaded with a single cell having a square pillar shape;
Fig. 4 is a perspective view showing the external appearance of a lead storage battery loaded with a plurality of columnar single cells;
Fig. 5 is a characteristic graph for comparing the characteristic of a wound lead storage battery according to the embodiment of the present invention and the characteristic of a stacked lead storage battery as a comparative example, the graph showing a rotation speed - torque characteristic of an electric power steering motor when the electric power steering motor is driven by using the wound lead storage battery according to the embodiment of the present invention and the stacked lead storage battery of the comparative example under a condition of the ambient temperature being set to -30°;
Fig. 6 is a characteristic chart showing changes with time in terminal voltage (battery voltage) of the wound lead storage battery according to the embodiment of the present invention, in charging current flowing into the wound lead storage battery, and in discharge current flowing out of the wound lead storage battery;
Fig. 7 is a sectional view showing the structure of the motor used in the electric power steering system according to the embodiment of the present invention;
Fig. 8 a sectional view showing the structure of the motor used in the electric power steering system according to the embodiment of the present invention, in which Fig. 8A is a sectional view taken along the line A-A in Fig. 7 and Fig. 8B is an enlarged sectional view of a portion P in Fig. 8A;
Fig. 9 is a table for explaining the relationship between the number of poles P of a rotor and the number of slots S of a stator in an AC motor;
Fig. 10 is a measurement graph showing the measured values of cogging torque of the motor used in the electric power steering system according to the embodiment of the present invention, in which Fig. 10A is a measurement graph showing the cogging torque (mNm) actually measured in the range of angle (mechanical angle) from 0 to 360° and Fig. 10B is a measurement graph showing the crest value (mNm) resulting when higher harmonic components of the cogging torque shown in Fig. 10A are separated into respective time orders;
Fig. 11 is a connection diagram showing the connection relationship of stator coils of the motor used in the electric power steering system according to the embodiment of the present invention;
Fig. 12 is a side view showing the connection state of the stator coils of the motor used in the electric power steering system according to the embodiment of the present invention;
Fig. 13 is a sectional view, taken along the line A-A in Fig. 7, showing another structure of the motor used in the electric power steering system according to the embodiment of the present invention;
Fig. 14 is an exploded perspective view showing the structure of a control unit used in the electric power steering system according to the embodiment of the present invention;
Fig. 15 is a perspective view showing the structure of the control unit used in the electric power steering system according to the embodiment of the present invention, the view illustrating a state where a power module and a conductor module are mounted on a casing, but a control module is not yet mounted;
Fig. 16 is a perspective view showing the structure of the conductor module in the control unit used in the electric power steering system according to the embodiment of the present invention, as viewed from the bottom surface side;
Fig. 17 is a sectional view, taken along the line X1-X1 in Fig. 15, showing the structure of the control unit used in the electric power steering system according to the embodiment of the present invention;
Fig. 18 is a sectional view showing the structure of the control unit used in the electric power steering system according to the embodiment of the present invention, the view illustrating the detailed structure of a connecting area between the power module and the conductor module;
Fig. 19 is a sectional view showing the structure of the control unit used in the electric power steering system according to the embodiment of the present invention, the view illustrating the detailed structure of a connecting area using a lead frame between the power module and the control module;
Fig. 20 is a circuit diagram showing the circuit configuration of the control unit used in the electric power steering system according to the embodiment of the present invention;
Fig. 21 is a perspective view showing another structure of the control unit used in the electric power steering system according to the embodiment of the present invention;
Fig. 22 is a circuit diagram showing the electrical circuit configuration of a power supply and an actuator, which are used in the electric power steering system according to the embodiment of the present invention;
Fig. 23 is a plan view showing the system construction of the electric power steering system according to the embodiment of the present invention;
Fig. 24 is a partial sectional perspective view showing the internal structure of the stacked lead storage battery of the comparative example; and
Fig. 25 is a characteristic chart showing changes with time in terminal voltage (battery voltage) of the stacked lead storage battery of the comparative example, in charging current flowing into the stacked lead storage battery, and in discharge current flowing out of the stacked lead storage battery.

### DESCRIPTION OF THE PREFERRED EMBODIMENTS

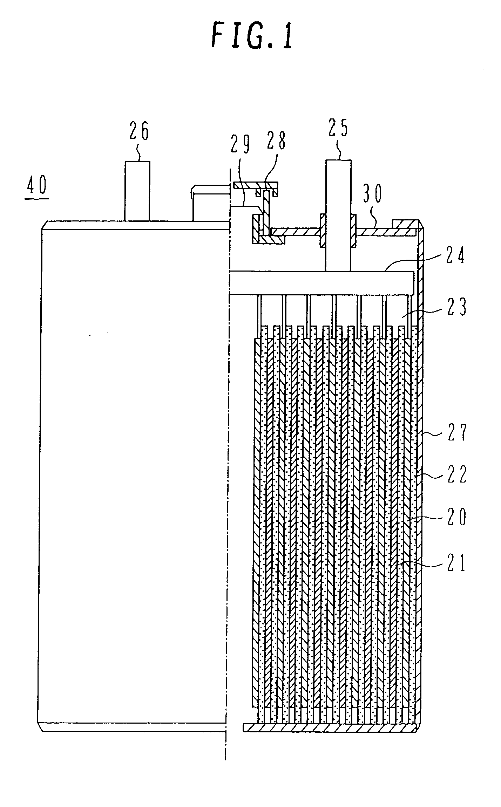

An embodiment of the present invention will be described below with reference to Figs. 1-23.

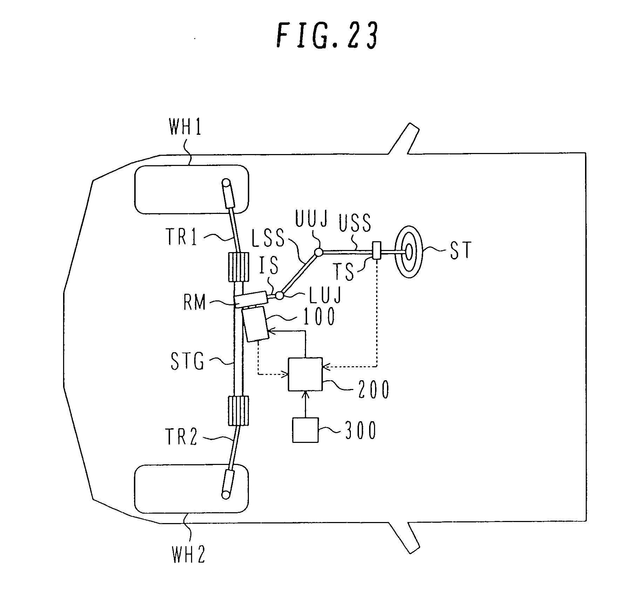

First, the general construction of an electric power steering system of the embodiment will be described with reference to Fig. 23.

Fig. 23 shows the system construction of the electric power steering system of the embodiment.

The electric power steering system (referred to as the "EPS system" hereinafter) of the embodiment is a pinion EPS system (referred to as a "P-EPS system" hereinafter) in which a pinion gear is assisted by an electric power steering motor 100 (referred to as an "EPS motor 100" hereinafter) disposed near a steering gear STG.

As other types of EPS systems, there are a column EPS system in which a column shaft is assisted by the EPS motor disposed near the column shaft, and a rack-cross EPS system in which a rack is assisted by the EPS motor disposed near the steering gear. The constructions of a power supply and an actuator in the P-EPS system of the embodiment are also applicable to those other types of EPS systems.

When a driver rotates a steering wheel STW, an applied main steering force (torque) is transmitted to the steering gear STG through an upper steering shaft USS, an upper universal joint UUJ, a lower steering shaft LSS, and a lower universal joint LUJ. An auxiliary steering force (torque) outputted from the EPS motor 100 is also transmitted to the steering gear STG.

The steering gear STG is a mechanism for transforming both the inputted main steering force (torque) and auxiliary steering force (torque) to linear reciprocating forces and transmitting the linear reciprocating forces to left and right tie rods TR1, TR2. The steering gear STG comprises a rack shaft (not shown) on which a rack gear (not shown) is formed, and a pinion shaft (not shown) on which a pinion gear (not shown) is formed. The rack gear and the pinion gear are meshed with each other in a motive power transformer PT in which the torque is transformed to the linear reciprocating forces. The main steering force is transmitted to the pinion shaft through an input shaft IS of the motive power transformer PT. The auxiliary steering force is transmitted to the pinion shaft through a speed reducing mechanism (not shown) of the motive power transformer PT.

The steering force having been transformed to the linear reciprocating forces by the steering gear STG is transmitted to tie rods TR1, TR2 coupled to the rack shaft and is then transmitted to left and right wheels WH1, WH2 from the tie rods TR1, TR2. The left and right wheels WH1, WH2 are thereby steered.

The upper steering shaft USS is provided with a torque sensor TS. The torque sensor TS detects the steering force (torque) applied to the steering wheel STW.

The EPS motor 100 is controlled by a control unit 200. The EPS motor 100 and the control unit 200 constitute the actuator of the EPS system. The EPS system employs an onboard battery 300 as a power supply. The control unit 200 functions as an inverter for, in accordance with an output of the torque sensor TS, converting DC power supplied from the battery 300 to multi-phase AC power so that the output torque of the EPS motor 100 is held at a target torque. The converted AC power is supplied to the EPS motor 100.

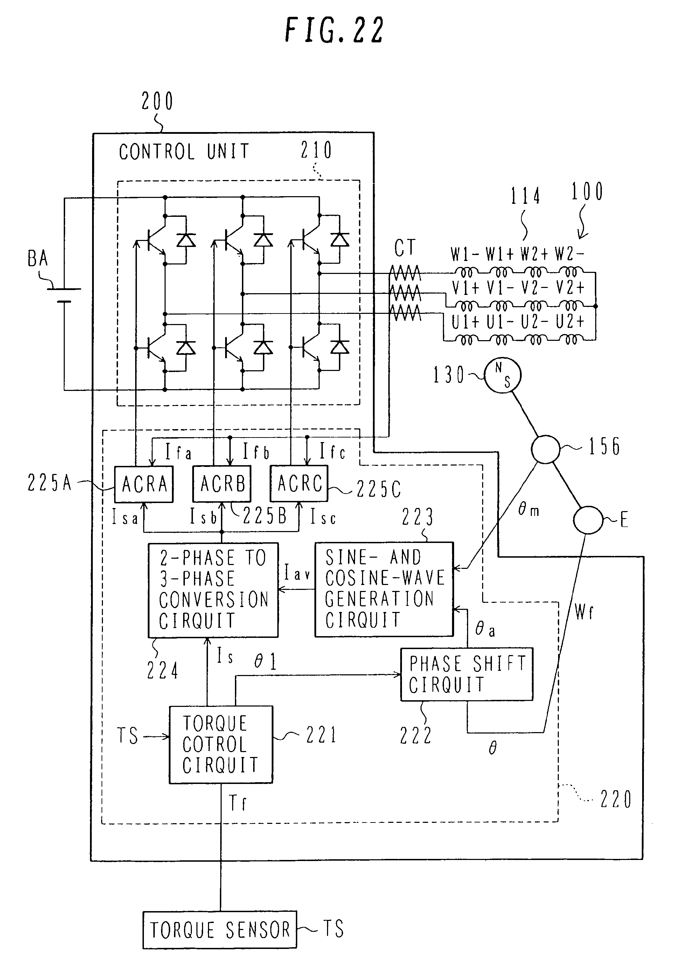

The electrical connection relationship in the power supply and the actuator, which are used in the EPS system of the embodiment, will be described below with reference to Fig. 22.

Fig. 22 shows the electrical circuit configuration of the power supply and the actuator both used in the EPS system according to the embodiment.

The control unit 200 comprises a power module 210 constituting an inverter main circuit (conversion circuit), and a control module 220 for controlling the on/off operations (switching operations) of power semiconductor switching devices in the power module 210. The inverter main circuit of the power module 210 is constituted as a 3-phase bridge circuit made up of six power semiconductor switching devices arranged in the bridge connection. The battery 300 is electrically connected to the input side (DC side) of the inverter main circuit of the power module 210, and stator coils 114 of the EPS motor 100 are electrically connected to the output side (AC side) thereof. By controlling the respective switching operations of the six power semiconductor switching devices in the power module 210 with the control module 220, the DC power outputted from the battery 300 is converted to the 3-phase AC power in the inverter main circuit of the power module 210, and the 3-phase AC power is supplied to the stator coils 114 of the EPS motor 100.

The control module 220 constitutes a control section that produces control signals for controlling the on/off operations (switching operations) of the power semiconductor switching devices and then outputs the control signals to driver circuits (not shown) of the power module 210. The control module 220 receives, as input parameters, a torque detected value Tf of the steering wheel STW detected by the torque sensor TS, a rotation speed detected value ωf of a rotor 130 detected by an encoder E, and a pole position detected value θm of the rotor 130 detected by a resolver 156.

The torque detected value Tf is inputted to a torque control circuit 221 along with a torque command value Ts. The torque control circuit 221 calculates a torque target value Te based on the torque detected value Tf and the torque command value Ts, and outputs a current command value Is and a rotation angle θ1 through a proportional and integral process, etc. of the calculated torque target value Te. The rotation angle θ1 is inputted to a phase shift circuit 222 along with the rotation speed detected value ωf. The phase shift circuit 222 calculates a rotation angle θa of the rotor 130 based on the rotation speed detected value ωf, and outputs the calculated rotation angle θa after making a phase shift based on the rotation angle θ1. The rotation angle θa is inputted to a sine- and cosine-wave generation circuit 223 along with the pole position detected value θm. The sine- and cosine-wave generation circuit 223 generates and outputs a sine-wave basic waveform (driving current waveform) value Iav obtained by making a phase shift of the voltage induced in each of windings (3-phase in the embodiment) of the stator coils 114 based on both the rotation angle θa and the pole position detected value θm. Incidentally, the amount of the phase shift may be set to zero in some cases.

The sine-wave basic waveform (driving current waveform) value Iav is inputted to a 2-phase to 3-phase conversion circuit 224 along with the current command value Is. Based on the sine-wave basic waveform (driving current waveform) value Iav and the current command value Is, the 2-phase to 3-phase conversion circuit 224 outputs current commands Isa, Isb and Isc corresponding to respective phases. The control module 220 includes current control systems 225A, 225B and 225C of the respective phases in one-to-one relation. The current control systems 225A, 225B and 225C of the respective phases receive the current commands Isa, Isb and Isc for the corresponding phases and current detected values Ifa, Ifb and Ifc for the corresponding phases, respectively. The current detected values Ifa, Ifb and Ifc are detected by respective current detectors CT and represent phase currents supplied from the conversion circuit of the power module 210 to the stator coils 114 of the respective phases. Based on the current commands Isa, Isb and Isc for the corresponding phases and the current detected values Ifa, Ifb and Ifc for the corresponding phases, the current control systems 225A, 225B and 225C of the respective phases output control signals for controlling the switching operations of the power semiconductor switching devices of the respective phases. The control signals of the respective phases are inputted to the driver circuits (not shown) of the power module 210 for the corresponding phases.

Based on the control signals of the respective phases, the driver circuits (not shown) of the power module 210 for the corresponding phases output driving signals for making the switching operations of the power semiconductor switching devices of the respective phases. The driving signals of the respective phases are inputted to the power semiconductor switching devices for the corresponding phases. When the power semiconductor switching devices perform the switching operations, the DC power supplied from the battery 300 is converted to the AC power that is supplied to the stator coils 114 of the EPS motor 100. At this time, a resultant current of the respective phase currents supplied to the stator coils 114 is always formed at a position orthogonal to the field magnetic flux or a phase-shifted position. As a result, the EPS motor 100 generates a rotating magnetic field depending on the rotational position of the rotor 130, whereby the rotor 130 is rotated.

The power supply used in the EPS system of the embodiment will be described in detail with reference to Figs. 1-6.

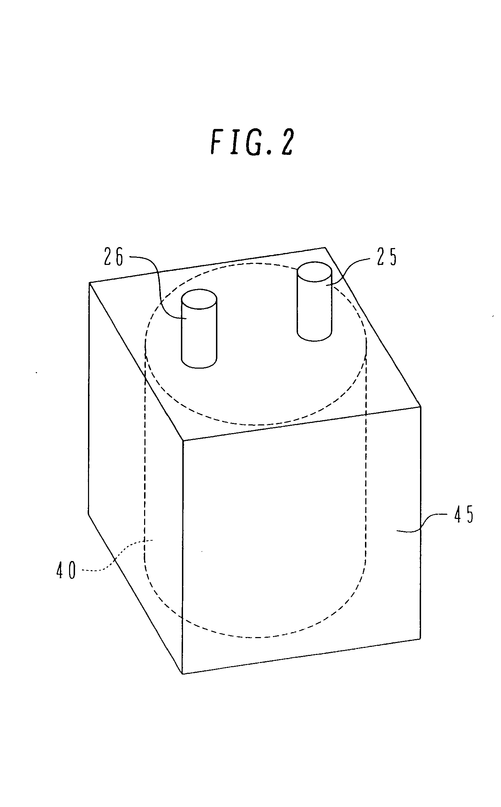

Fig. 1 shows the internal structure of a single cell of a lead storage battery used as a power supply of the EPS system of the embodiment. Fig. 2 shows the external appearance of the lead storage battery loaded with the columnar single cell shown in Fig. 1.

According to the embodiment, a wound lead storage battery is used as the lead storage battery. The single cell of the wound lead storage battery of the embodiment is manufactured as described below. Thus, a single cell 40 having the internal structure shown in Fig. 1 is obtained as follows.

A negative plate 20 and a positive plate 21 are wound into the spiral form having a circular cross-section with a 0.35-mm thick separator 22 interposed between both the plates. After leaving the spiral body to stand at temperature of 45°C at humidity of 93% for 16 hours for aging, it is dried at temperature of 110°C for 1 hour. Then, ten plate lugs 23 of the same polarity are connected to each other by one strap 24, and twos straps 24 of the negative and positive polarities are welded respectively to a negative terminal 25 and a positive terminal 26, thereby fabricating a wound plate unit. After loading the wound plate unit in a columnar cell casing 27, a cover 28 is placed at a top of the cell casing 27 and is fixedly welded to the top. Then, an electrolyte of dilute sulfuric acid with specific gravity of 1.2 (20°C) is poured into the cell casing 27 through a pouring port 29, to thereby fabricate the single cell 40 that is not yet subjected to formation. After subjecting the single cell 40 to the formation at 9 A for 20 hours, a solution of dilute sulfuric acid with specific gravity of 1.4 (20°C) is added for adjustment so that an electrolyte of sulfuric acid having a concentration with specific gravity of 1.3 (20°C) is obtained. Finally, a safety valve 30 is fitted in place, to thereby obtain the columnar single cell 40.

The negative plate 20 not yet subjected to the formation is manufactured through the steps of fabricating a negative current collector formed of a Pb alloy foil having a thickness of 0.2 mm and containing 2.2 weight% of Sn, coating 45 g of a negative-electrode activating material paste on the front and rear surfaces of the foil, and finally shaping it into a plate having a thickness of 0.8 mm.

Here, the negative current collector is in the form of a rolled sheet having a thickness of 0.25 mm manufactured by producing a Pb alloy containing 2.2 weight% of Sn with smelting, and by cold-rolling the alloy.

The negative-electrode activating material paste is obtained through the steps of forming a mixture of 0.3 weight% of lignin, 0.2 weight% of barium sulfate or strontium sulfate, 0.1 weight% of carbon powder, and the balance of lead powder while kneading the mixture for about 10 minutes by a kneader, adding 12 weight% of water and kneading the mixture, and then adding 13 weight% of dilute sulfuric acid at 20°C with specific gravity of 1.24 to the kneaded lead powder, followed by further kneading the mixture.

The positive plate 21 not yet subjected to the formation is manufactured through the steps of fabricating a positive current collector formed of a Pb - 2.2 Sn alloy foil having a thickness of 0.25 mm, coating 45 g of a positive-electrode activating material paste on the front and rear surfaces of the foil, and finally shaping it into a plate having a thickness of 0.8 mm.

Here, the positive current collector is in the form of a rolled sheet having a thickness of 0.25 mm manufactured by producing a Pb alloy containing 2.2 weight% of Sn with smelting, and by cold-rolling the alloy.

The positive-electrode activating material paste is obtained, similarly to the negative-electrode activating material paste, through the steps of forming a mixture of 0.3 weight% of lignin, 0.2 weight% of barium sulfate or strontium sulfate, 0.1 weight% of carbon powder, and the balance of lead powder while kneading the mixture for about 10 minutes by a kneader, adding 12 weight% of water and kneading the mixture, and then adding 13 weight% of dilute sulfuric acid at 20°C with specific gravity of 1.24 to the kneaded lead powder, followed by further kneading the mixture.

The columnar single cell 40 is, as shown in Fig. 2, placed in an outer casing 45 having a square pillar or box-like (parallelepiped) shape. The positive terminal 26 and the negative terminal 25 are projected upward from an upper surface of the outer casing 45.

The positive plate 21 of the single cell 40 is formed so as to have an area of 1500 - 15000 cm².

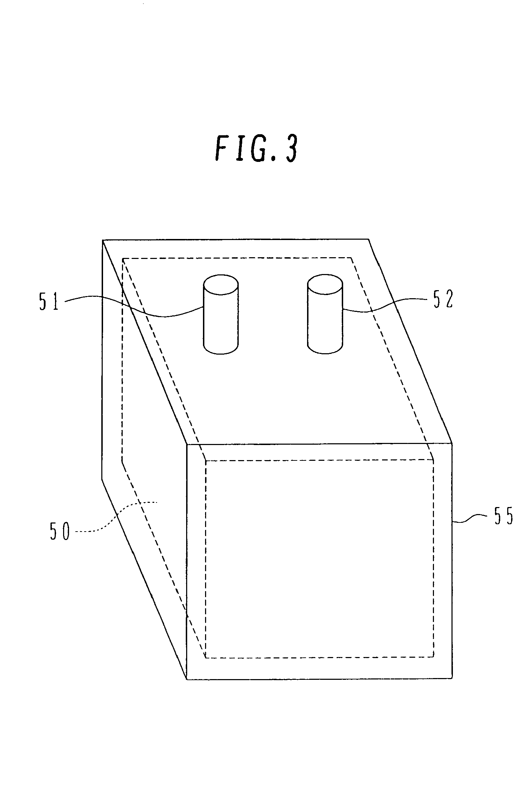

While the single cell 40 has been described as having a columnar shape, for example, with reference to Figs. 1 and 2, it may be shaped as shown in Fig. 3.

Fig. 3 shows the external appearance of the lead storage battery loaded with a single cell having a square pillar shape.

A single cell 50 shown in Fig. 3 has a cell casing 27 having a square pillar or box-like (parallelepiped) shape.
A negative plate and a positive plate are wound into the spiral form having a rectangular (square) cross-section with a separator interposed between both the plates such that a group of electrode plates are laid in the cell casing 27 to follow the casing shape. The single cell 50 is placed in an outer casing 55 having a square pillar or box-like (parallelepiped) shape. A positive terminal 51 and a negative terminal 52 are projected upward from an upper surface of the outer casing 55.

The lead storage battery shown in Fig. 3 has a smaller dead space between the single cell and the outer casing, and is therefore more efficient than the battery shown in Fig. 2.

The positive plate of the single cell 50 is formed so as to have an area of 1500 - 15000 cm².

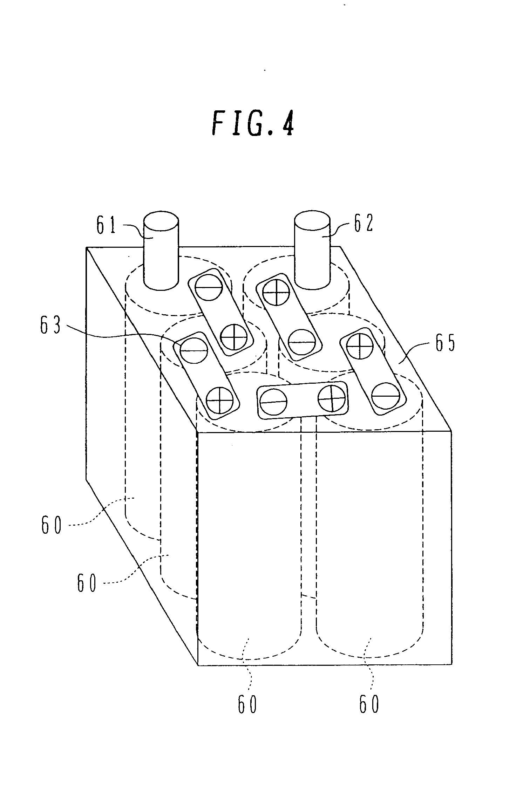

While Figs. 1 and 2 illustrate, by way of example, the case of one columnar single cell 40 being placed in one outer casing 55, a plurality of single cells 60 may be placed in one outer casing 55 as shown in Fig. 4.

Fig. 4 shows the external appearance of a lead storage battery loaded with a plurality of columnar single cells.

The single cell 60 shown in Fig. 4 has the same structure as the single cell 40 shown in Fig. 1. In the illustrated example, six single cells 60 are electrically connected in series by connecting terminals 63 and are placed in an outer casing 65 having a square pillar or box-like (parallelepiped) shape. A positive terminal 61 of the single cell 60 positioned at one end in the electrical arrangement and a negative terminal 62 of the single cell 60 positioned at the other end in the electrical arrangement are projected upward from an upper surface of the outer casing 65.

The lead storage battery thus constructed has a design capacity of 24 - 34 Ah and an average discharge voltage of 12 V.

Also, maximum outer dimensions of the lead storage battery shown in Fig. 4 are given as a battery volume of 5.4 dm³ (that is the same as the volume of a lead storage battery of model 38B19 described later as a comparative example) when estimated on an assumption of the battery being parallelepiped.

The positive plate of each single cell 60 is formed so as to have an area of 1500 - 15000 cm².

Further, when the maximum outer dimensions of the lead storage battery shown in Fig. 4 are estimated on an assumption of the battery being parallelepiped, the positive electrode (plate) area per unit volume of the lead storage battery is 1700 - 17000 cm²/dm³.

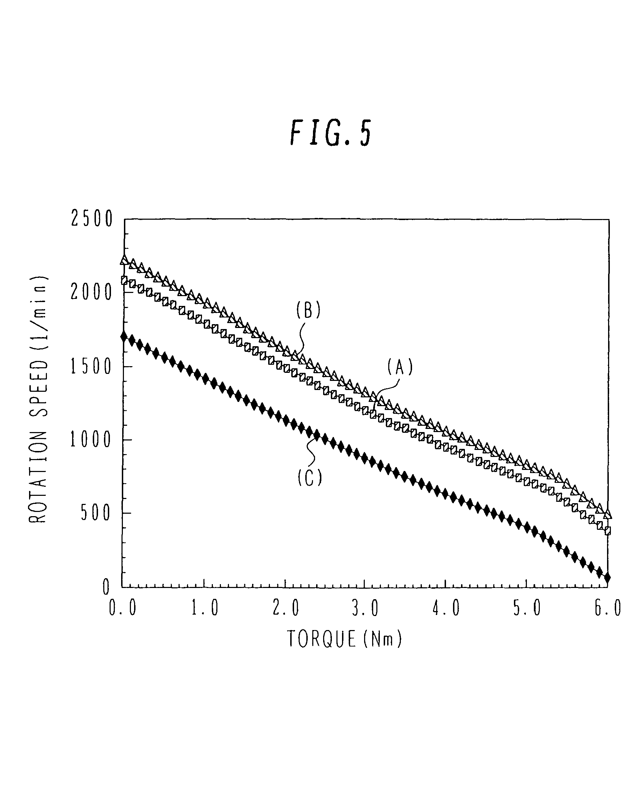

Fig. 5 is a characteristic graph for comparing the characteristic of the lead storage battery of the embodiment, shown in Fig. 4, and the characteristic of a lead storage battery as a comparative example, the graph showing a rotation speed - torque characteristic of the EPS motor 100 when the EPS motor 100 is driven by using the lead storage battery of the embodiment and the lead storage battery of the comparative example under a condition of the ambient temperature being -30°C.

Prior to describing the characteristic of the lead storage battery of the embodiment with reference to Fig. 5, the lead storage battery of the comparative example will be described below.

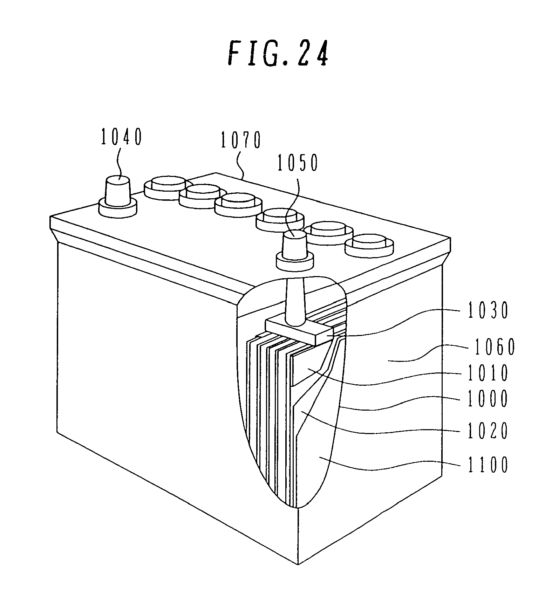

Fig. 24 shows the structure of the lead storage battery of the comparative example.

The lead storage battery of the comparative example is a stacked lead storage battery (output voltage: 12 V) that has hitherto been mounted on an automobile as an onboard battery constituting a 14V onboard power supply system. The stacked lead storage battery is manufactured as follows.

Five negative plates 1000 and four positive plates 1010 are horizontally stacked while a separator 1020 made of polyethylene having a thickness of 1.5 mm is interposed between those negative and positive plates. The plates having the same polarity are connected to each other by a strap 1030, thereby fabricating a plate group 1100. Then, after arranging six plate groups 1100 in a battery casing 1060 and connecting them in series, an electrolyte of dilute sulfuric acid with specific gravity of 1.05 (20°C) is poured into the battery casing, to thereby fabricate a battery that is not yet subjected to formation. After subjecting the battery to the formation at 9 A for 20 hours, a solution of dilute sulfuric acid with specific gravity of 1.4 (20°C) is added for adjustment so that an electrolyte of sulfuric acid having a concentration with specific gravity of 1.3 (20°C) is obtained. Then, the stacked lead storage battery is obtained by welding a positive terminal 1050 and a negative terminal 1040 to the corresponding straps, and by fitting a cover 1070 in an sealing-off manner.

The negative plate 1000 not yet subjected to the formation is manufactured through the steps of coating 45 g of a negative-electrode activating material paste on a negative current collector having a thickness of 1 mm, leaving the negative current collector to stand at temperature of 45°C at humidity of 93% for 16 hours for aging, followed by drying at temperature of 110°C for 1 hour, and finally shaping it into a plate having a thickness of 1.3 mm.

Here, the negative current collector is obtained through the steps of forming a Pb alloy containing 1 weight% of Sn and 0.2 weight% of Ca with smelting, cold-rolling the alloy to fabricate a rolled sheet, and expanding the rolled sheet into the negative current collector having a thickness of 1 mm.

The negative-electrode activating material paste is obtained through the steps of forming a mixture of 0.3 weight% of lignin, 0.2 weight% of barium sulfate or strontium sulfate, 0.1 weight% of carbon powder, and the balance of lead powder while kneading the mixture for about 10 minutes by a kneader, adding 12 weight% of water and kneading the mixture, and further adding 13 weight% of dilute sulfuric acid at 20°C with specific gravity of 1.24 to the kneaded lead powder, followed by further kneading the mixture.

The positive plate 1010 is manufactured through the steps of coating 45 g of a positive-electrode activating material paste on a positive current collector having a thickness of 1 mm and made of a Pb alloy containing 1 weight% of Sn, leaving the positive current collector to stand at temperature of 45°C at humidity of 93% for 16 hours for aging, followed by drying at temperature of 110°C for 1 hour, and finally shaping it into a plate having a thickness of 1.6 mm.

Here, the positive current collector is obtained through the steps of forming a Pb alloy containing 1 weight% of Sn and 0.7 weight% of Ca with smelting, cold-rolling the alloy to fabricate a rolled sheet, and expanding the rolled sheet into the positive current collector having a thickness of 1 mm.

The positive-electrode activating material paste is obtained through the steps of forming a mixture of 0.3 weight% of lignin, 0.2 weight% of barium sulfate or strontium sulfate, 0.1 weight% of carbon powder, and the balance of lead powder while kneading the mixture for about 10 minutes by a kneader, adding 12 weight% of water and kneading the mixture, and further adding 13 weight% of dilute sulfuric acid at 20°C with specific gravity of 1.24 to the kneaded lead powder, followed by further kneading the mixture.

The thus-constructed lead storage battery of the comparative example has a design capacity of 28 Ah and an average discharge voltage of 12 V.

Also, the lead storage battery of the comparative example is a battery of model 38B19 and has a battery volume of 5.4 4 dm³.

Further, the lead storage battery of the comparative example has a total positive electrode area of 5400 cm², a positive electrode area of 1000 cm²/ dm³ per unit volume of the rectangular battery, and a positive electrode area of 900 cm² per single cell.

In Fig. 5, a characteristic (A) represents actually measured values for the wound lead storage battery of the embodiment in which the area of the positive plate per single cell is 1500 cm² and the positive electrode area of the lead storage battery per unit volume is 1700 cm²/dm³. A characteristic (B) represents actually measured values for the wound lead storage battery of the embodiment in which the area of the positive plate per single cell is 15000 cm² and the positive electrode area of the lead storage battery per unit volume is 17000 cm²/dm³. A characteristic (C) represents actually measured values for the stacked lead storage battery of the comparative example in which the area of the positive plate per single cell is 900 cm² and the positive electrode area of the lead storage battery per unit volume is 1000 cm²/dm³.

As seen from Fig. 5, the wound lead storage batteries of the embodiment, which are represented by the characteristics (A) and (B), can produce a higher rotation speed of the EPS motor 100 at the same torque and larger torque of the EPS motor 100 at the same rotation speed than those produced by the stacked lead storage batteries of the comparative example, which is represented by the characteristic (C). Accordingly, by using the wound lead storage battery of the embodiment as the power supply of the EPS system, a higher output of the EPS system can be achieved.

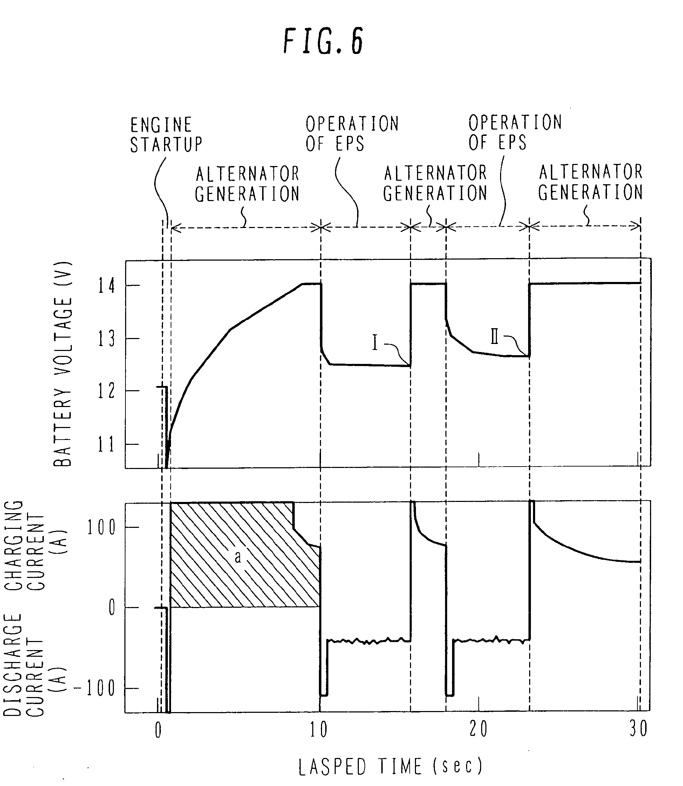

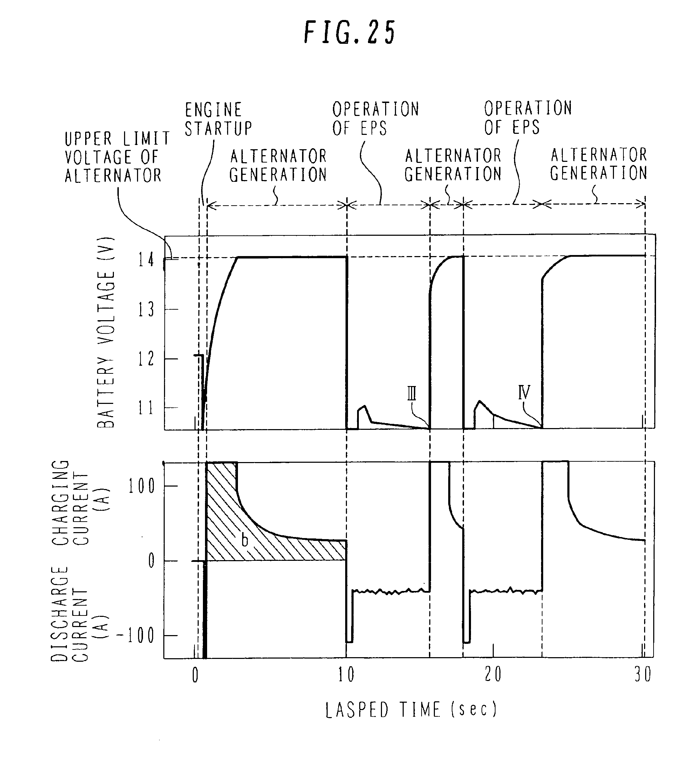

Further, the characteristic of the wound lead storage battery of the embodiment and the characteristic of the lead storage battery of the comparative example are compared with each other with reference to Figs. 6 and 25.

Figs. 6 and 25 each show changes with time in terminal voltage (battery voltage) of the lead storage battery, in charging current flowing into the lead storage battery, and in discharge current flowing out of the lead storage battery.

As mentioned above, the EPS motor 100 is driven by power supplied from the onboard power supply. When the known lead storage battery, i.e., the stacked lead storage battery of the comparative example, is used as the onboard power supply, the output voltage of the onboard power supply is fairly low in many cases. More specifically, electrically equivalently connected serial circuits, which include the power semiconductor switching devices constituting the conversion circuit of the inverter 200, the EPS motor 100, and other connection means in a current supply circuit, are electrically connected between terminals of the onboard power supply, and a total of terminal voltages of circuit component devices of each serial circuit provides the voltage between the terminals of the onboard power supply. For that reason, the terminal voltage of the EPS motor 100 obtained for supply of currents to the EPS motor 100 is fairly low.

The EPS motor 100 is required to output large torque. This requirement is attributable to the necessity of overcoming the frictional resistance caused between the steered wheels and the ground surface in order to perform steering of the steered wheels, for example, even when the steering wheel is quickly rotated in the state where a vehicle is stopped or in the state where it is running at a very low speed. When the required torque is outputted from an AC servomotor using AC 100 V as a power source, a motor current is about 5 A. However, when the AC servomotor is driven using the stacked lead storage battery of the comparative example with the 14V AC power obtained through DC-AC conversion of the 14V DC power, a motor current of 70 A - 100 A is required to output substantially the same torque with substantially the same volume.

When the wound lead storage battery of the embodiment held in 70% of the state of charge (SOC) in advance and the stacked lead storage battery of the comparative example held in the same state are mounted on a vehicle as the power supply of the above-described EPS system shown in Fig. 23, characteristics of changes with time in terminal voltages (battery voltages) of those lead storage batteries, in charging currents flowing into those lead storage batteries, and in discharge currents flowing out of those lead storage batteries are measured respectively as shown in Figs. 6 and 25.

An engine is started up, for example, by a starter motor that is usually employed. At the startup of the engine, when an ignition key is turned on, a current is supplied to the starter motor to rotate the engine. On that occasion, because a large current is momentarily supplied to the starter motor from each of the wound lead storage battery and the stacked lead storage battery, the battery voltage is momentarily reduced to 11 V or below.

When the engine is started, charging to the wound lead storage battery and the stacked lead storage battery is started from an alternator. At this time, the battery voltages of the wound lead storage battery and the battery voltage of the stacked lead storage battery are each charged at a constant voltage of, e.g., 14 V. Also, a charging current is changed depending on the rotation speed of the alternator.

In the stacked lead storage battery of the comparative example, because it has a lower charge accepting capability than the wound lead storage battery of the embodiment, the battery voltage reaches an upper limit voltage of 14 V after several seconds after the start of the charging, and the charging current starts to attenuate. Thus, it can be said in the stacked lead storage battery that the power generated by the alternator is consumed as heat rather than the charging of the stacked lead storage battery, and therefore the charging efficiency (ratio of the amount of electricity generated by the alternator to the amount of electricity charged in the storage battery) is low. The amount of electricity charged in the stacked lead storage battery in such a state corresponds to the area of a hatched region b shown in Fig. 25.

On the other hand, in the wound lead storage battery of the embodiment, because it has a higher charge accepting capability than the stacked lead storage battery of the comparative example, the charging can be performed at a large current immediately after the start of the charging. Thus, it can be said in the wound lead storage battery that the power generated by the alternator is all consumed for the charging of the wound lead storage battery until the battery voltage reaches an upper limit voltage of 14 V, and therefore the charging efficiency (ratio of the amount of electricity generated by the alternator to the amount of electricity charged in the storage battery) is high. After the lapse of about 7 seconds from the start of the charging, the battery voltage of the wound lead storage battery reaches the upper limit voltage of 14 V, and the charging current starts to attenuate. The amount of electricity charged in the wound lead storage battery in such a state corresponds to the area of a hatched region a shown in Fig. 6, which is larger than the area of the hatched region b, shown in Fig. 25, obtained with the stacked lead storage battery of the comparative example.

The steering operation is performed after the lapse of 10 seconds from the engine startup. When the steering wheel is quickly rotated in the state where the vehicle is stopped, the EPS motor 100 produces large torque in order to overcome the frictional resistance caused between the steered wheels and the ground surface, to thereby perform steering of the steered wheels. At this time, a current of 100 A or more is momentarily supplied from each of the wound lead storage battery and the stacked lead storage battery to the actuator side. Then, the current supplied from each of the wound lead storage battery and the stacked lead storage battery to the actuator side is reduced with running of the vehicle.

More specifically, in the stacked lead storage battery of the comparative example, because it has a lower output capability than the wound lead storage battery of the embodiment, the battery voltage is largely reduced to a level below 11 V at a point III in time. Then, charging of the stacked lead storage battery is performed again by the alternator, and the EPS motor 100 is driven in the slowly running state not so differing from the stopped state. Correspondingly, as at the point III in time, the battery voltage is largely reduced to a level below 11 V at a point IV in time. As a result, a drop of the terminal voltage of the EPS motor 100 cannot be suppressed in the stacked lead storage battery of the comparative example.

On the other hand, in the wound lead storage battery of the embodiment, because the output capability is increased twice or more that of the stacked lead storage battery of the comparative example, the battery voltage at a point I in time (that is the same as the point III in time in Fig. 25) can be maintained at a high voltage of not lower than 12 V even after the discharge of a large current. Then, charging of the wound lead storage battery is performed again by the alternator, and the EPS motor 100 is driven in the slowly running state not so differing from the stopped state. However, the battery voltage at a point II in time (that is the same as the point IV in time in Fig. 25) can be maintained at a high voltage of not lower than 12 V. As a result, a drop of the terminal voltage of the EPS motor 100 can be suppressed in the wound lead storage battery of the embodiment.

Various kinds of vibrations are applied to the storage battery mounted on an automobile. In addition, impacts are also applied from wheels to the storage battery mounted on the automobile. In the embodiment, however, since the wound lead storage battery is used as the onboard storage battery, winding pressure is uniformly applied to the electrode surface. In spite of the application of vibrations and impacts, therefore, the activating material is not slipped off and battery deterioration can be suppressed. A spiral cylindrical structure is desired from the viewpoint of that the winding pressure applied to the electrode surface becomes most uniform.

Further, the storage battery mounted on the automobile is used even under environments subjected to large changes of the atmospheric temperature. Therefore, the current and the voltage are required at levels enough to normally operate the EPS motor 100 even under a condition where the storage battery is at a temperature of -30°C. The wound lead storage battery of the embodiment exhibits a superior output characteristic even under such a condition of -30°C. Thus, the wound lead storage battery of the embodiment can provide a better rotation speed - torque characteristic of the EPS motor 100 than the case using the stacked lead storage battery of the embodiment.

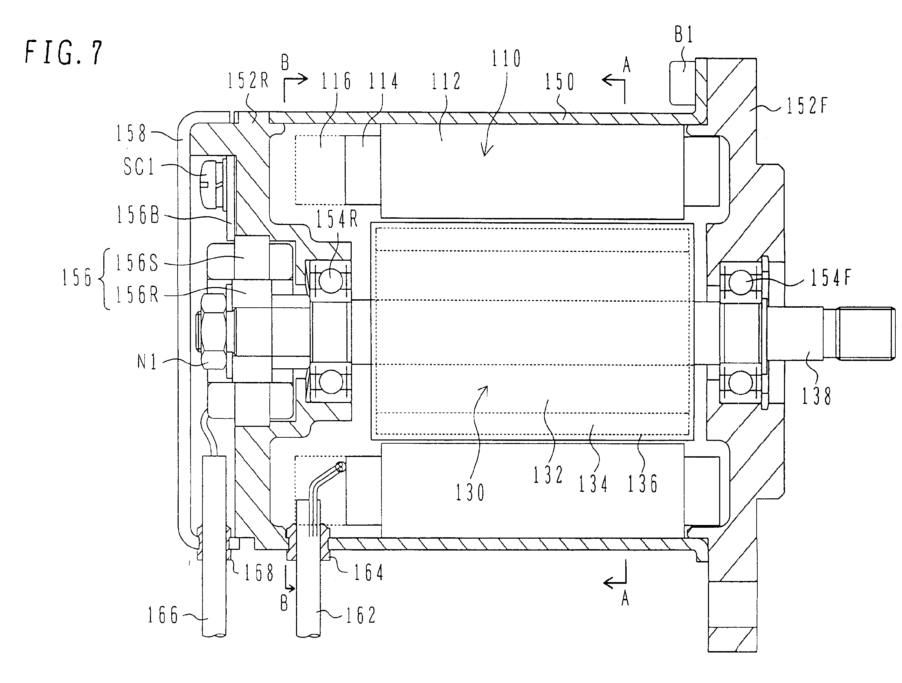

The EPS motor used in the EPS system of the embodiment will be described in detail below with reference to Figs. 7-13.

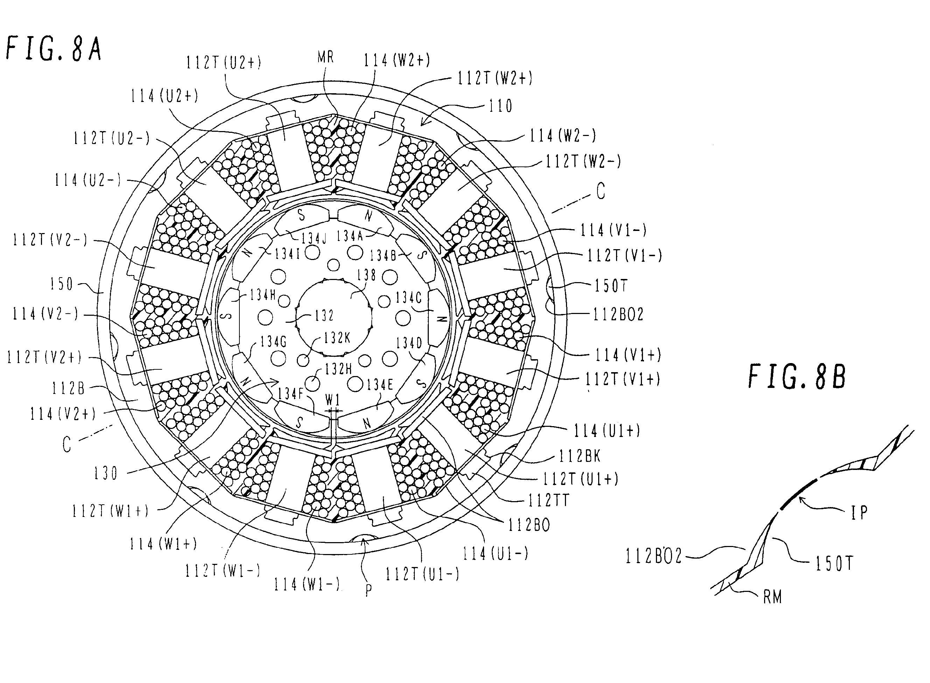

Fig. 7 shows the overall structure of the EPS motor used in the EPS system of the embodiment. Fig. 8A shows a section taken along the line A-A in Fig. 7 and Fig. 8B shows an enlarged section of a portion P in Fig. 8A.

The EPS motor 100 of the embodiment operates using the onboard battery (output voltage of, e.g., 12 V) as a power supply, and it is disposed near the steering wheel or the steering gear. From such a restriction on the mount position, therefore, the EPS motor 100 is required to have a smaller size. On the other hand, from the viewpoint of assisting the steering with the motor power, the EPS motor 100 is also required to output large torque (e.g., 4.5 Nm).

The EPS motor 100 is a synchronous motor of the surface magnet type comprising a stator 110 and a rotor 130 rotatably supported inside the stator 110. The EPS motor 100 is driven by electric power supplied from a 14V power supply system including the wound lead storage battery of the embodiment (output voltage of the wound lead storage battery being 12 V). As other onboard power supply systems, there are a 24V power supply system, a 42V power supply system (output voltage of the battery being 36 V), and a 48V power supply system. Thus, the voltage of the power supply for driving the EPS motor 100 is changed depending on the type of automobile. The EPS system of the embodiment is adaptable for any type of those power supply systems.

The stator 110 comprises a stator core 112 formed of a magnetic member which is fabricated by laminating silicon steel sheets, and a stator coil 114 held in each of slots formed in the stator core 112. The stator core 112 is made up of, as described later with reference to Fig. 8, an annular back core and a plurality of teeth which are fabricated separately from the back core and thereafter mechanically fixed to the back core. The stator coil 114 is wound over each of the plurality of teeth. The stator coil 114 is formed in a distributed winding or concentrated winding way.

The stator coil 114 with the distributed winding is superior in field-weakening control and in generation of reluctance torque. In the EPS motor, it is very important to reduce the motor size and the winding resistance. The stator coil 114 with the concentrated winding is advantageous in shortening the coil end length of the stator coil 114, to thereby shorten the length of the EPS motor 100 in the direction of axis of its rotation. Also, the shortening of the coil end length of the stator coil 114 reduces the resistance of the stator coil 114 and suppresses a rise of the motor temperature. Further, the smaller coil resistance results in a smaller copper loss of the motor.
It is hence possible to reduce a proportion of a part of energy inputted to the motor, which is consumed by the copper loss, and to increase the efficiency of output torque with respect to the input energy.

When the EPS motor is disposed near the steering column, the EPS motor is required to have a smaller size in any layout including the case where it is disposed near the rack and pinion. In addition, because stator windings have to be fixed in a smaller-sized structure, easier winding operation is also important. The concentrated winding is easier in the winding operation and the winding fixing operation than the distributed winding.

The coil end of the stator coil 114 is molded with a resin. Because it is desired in the EPS motor that torque fluctuations, such as cogging torque, are minimized, the interior of the stator is often subjected to cutting again after assembly of the stator. Such a machining process generates chip. From the necessity of preventing the chip from entering the coil end of the stator coil, the coil end is preferably molded. The term "coil end" means one of plural portions of the stator coil 114, which is axially projected from corresponding one of axial opposite ends of the stator core 112. In the embodiment, gaps are left between the molded resin covering the coil ends of the stator coil 114 and a frame 150, but the resin may be filled so as to contact with the frame 150, a front flange 152F, and a rear flange 152R. Such full filling of the resin is advantageous in transmitting heat generated by the stator coil 114 directly from coil ends to the frame 150, the front flange 152F, and the rear flange 152R through the molded resin for dissipation to the exterior, and therefore suppressing a temperature rise of the stator coil 114 in comparison with the case of transmitting the generated heat via air.

The stator coil 114 is constituted as coils for three phases, i.e., U-, V- and W-phase, and each coil is made up of a plurality of unit coils. The plurality of unit coils for each of the three phases are interconnected, as shown in Fig. 7, by a connecting ring 116 disposed on the left end as viewed in the drawing.

The EPS motor is often required to output large torque. For example, when the steering wheel is quickly rotated in the state where a vehicle is stopped or in the state where it is running at a very low speed, the EPS motor is required to output large torque in order to overcome the frictional resistance caused between the steered wheels and the ground surface. On that occasion, a large current is supplied to the stator coil. The current reaches 100 A or more though depending on conditions. The use of the connecting ring 116 is very important from the viewpoints of supplying such a large current with safety and reducing heat generated by the large current. By supplying the current to the stator coil through the connecting ring 116, the connection resistance can be reduced and a voltage drop due to the copper loss can be suppressed. This facilitates the supply of the large current. As still another advantage, the time constant in rising of the current upon operation of devices in the inverter can be reduced.

The stator core 112 and the individual stator coils 114 are integrally molded with a (electrically insulating) resin to constitute an integral stator SubAssy. The integral stator SubAssy is obtained by press-fitting the stator core 112 and the stator coils 114 in a cylindrical frame 150 made of a metal, e.g., aluminum, and molding them in the state being fixed inside the frame 150 with the resin. As an alternative, the integral stator SubAssy may be obtained by molding the stator core 112 and the stator coils 114 with the resin in the state where the stator coils 114 are assembled in the stator core 112, and then press-fitting the assembly into the frame 150.

The EPS system mounted on the automobile is subjected to not only various vibrations, but also impacts from the wheels. Also, the EPS system is used under a condition of large changes of the atmospheric temperature. In some cases, the EPS system is exposed to a condition of -40°C or in excess of 100°C due to a local temperature rise. Further, the motor has to be protected against intrusion of water. In order to fix the stator in the yoke 150 to be endurable even under those conditions, the stator SubAssy is desirably press-fitted into the cylindrical frame such that a cylindrical metallic member of the frame has no holes other than screw holes at least in its portion located around a stator core. After the press fitting, the stator may be further fixed from the outer peripheral side of the frame by using screws. Any suitable means for checking rotation is preferably provided in addition to the press fitting.

The rotor 130 comprises a rotor core 132 formed of a magnetic member which is fabricated by laminating silicon steel sheets, a plurality of magnets 134 in the form of permanent magnets fixed to the surface of the rotor core 132 by an adhesive, and a magnet cover 136 made of a nonmagnetic substance and disposed around the magnets 134. The magnets 134 are each a magnet made of a rare earth element, e.g., neodymium. The rotor core 132 is fixed to a shaft 138.
With the arrangement that the plurality of magnets 134 are fixed to the surface of the rotor core 132 by the adhesive and the magnet cover 136 is disposed around the magnets 134 so as to cover them from the outer side, the magnets 134 are prevented from scattering away. The magnet cover 136 is made of stainless steel (so-called SUS). A tape may be wound over the magnets instead, but using the magnet cover 136 made of stainless steel is easier to manufacture the motor. The EPS motor having the above-described structure is superior in reliably holding the permanent magnets in place, which are subjected to very large vibrations and thermal changes and are rather apt to break. Moreover, the magnets can be prevented from scattering away even if they are broken.

The front flange 152F is disposed at one end of the cylindrical frame 150. The frame 150 and the front flange 152F are fixed to each other by bolts B1. The rear flange 152R is press-fitted to the other end of the frame 150. The front flange 152F and the rear flange 152R are provided with bearings 154F, 154R, respectively. The shaft 138 and the stator 110 fixed to the shaft 138 are rotatably supported by the bearings 154F, 154R.

The front flange 152F is provided with an annular projected (extended) portion. The projected portion of the front flange 152F is axially projected toward the coil end from its lateral surface facing the coil end. The projected portion of the front flange 152F has a distal end formed such that, when the front flange 152F is fixed to the frame 150, the distal end is inserted in a gap defined between the molded resin over the coil end on the same side as the front flange 152F and the frame 150. Also, to increase heat release from the coil end, the projected portion of the front flange 152F is preferably held in close contact with the molded resin over the coil end on the same side as the front flange 152F.

The rear flange 152R has a cylindrical recess. The cylindrical recess of the rear flange 152R is concentric with the axis of the shaft 138 and is located at an axially more inner position (nearer to the stator core 112) than the corresponding axial end of the frame 150. A distal end of the cylindrical recess of the rear flange 152R is extended to a position radially inside the coil end on the same side as the rear flange 152R such that the distal end is opposed to the coil end on the same side as the rear flange 152R in the radial direction. A bearing 154 is disposed at the distal end of the cylindrical recess of the rear flange 152R. An axial end of the shaft 138 on the same side as the rear flange 152R is extended axially outward (in the direction opposite to the rotor core 132) beyond the bearing 154 to such an extent that the axial end is positioned near an opening of the cylindrical recess of the rear flange 152R or it is somewhat projected axially outward of the opening.

A resolver 156 is disposed in a space formed between an inner peripheral surface of the cylindrical.recess of the rear flange 152R and an outer peripheral surface of the shaft 138. The resolver 156 comprises a resolver stator 156S and a resolver rotor 156R. The resolver 156 is positioned axially outward of the bearing 154R (in the direction opposite to the rotor core 132). The resolver rotor 156R is fixed to one end of the shaft 138 (left end as viewed in the drawing) by a nut N1. The resolver stator 156S is fixedly held inside the cylindrical recess of the rear flange 152R in opposed relation to the resolver rotor 156R, while a gap is left between them, through a resolver retainer plate 156B that is fixed to the rear flange 152R by a screw SC1. The resolver stator 156S and the resolver rotor 156R cooperatively constitute the resolver 156. Respective positions of the plurality of magnets 134 can be detected by detecting the rotation of the resolver rotor 156R with the resolver stator 156S. More specifically, the resolver 156 comprises the resolver rotor 156R having an uneven outer circumferential surface (in the form of, e.g., an ellipse or a flower leaf), and the resolver stator 156S including two output coils (electrically shifted 90° from each other) and an excitation coil, which are wound over a core. When an AC voltage is applied to the excitation coil, AC voltages are generated in the two output coils depending on changes in length of the gap between the resolver rotor 156R and the resolver stator 156S with a phase difference proportional to the rotational angle. In such a way, the resolver detects two output voltages with a phase difference between them. The magnetic pole position of the rotor 130 can be detected by determining a phase angle based on the phase difference between the two detected output voltages. A rear holder 158 is mounted to an outer periphery of the rear flange 152R so as to cover the resolver 156.

From the external battery, electric power is supplied through a power cable 162 to the stator coils of the U-, V-and W-phases, which are interconnected by the respective connecting rings 116 per phase. The power cable 162 is mounted to the frame 150 through a grommet 164. A pole position signal detected by the resolver stator 156S is taken out to the exterior via a signal cable 166. The signal cable 166 is mounted to the rear holder 158 through a grommet 168. The connecting rings 116 and a part of the power cable 162 are molded with the resin together with the corresponding coil end.

The structures of the stator 110 and the rotor 130 will be described in more detail below.

The stator core 112 is made up of an annular back core 112B and a plurality of teeth 112T separate from the back core 112B. The back core 112B is fabricated by punching sheets made of a magnetic substance, e.g., silicon steel sheets, by pressing, and then laminating the punched sheets in multiple layers.

In the embodiment, the teeth 112T is made up of 12 teeth 112T(U1+), 112T(U1-), 112T(U2+), 112T(U2-), 112T(V1+), 112T(V1-), 112T(V2+), 112T(V2-), 112T(W1+), 112T(W1-), 112T(W2+) and 112T(W2-). Stator coils 114(U1+), 114(U1-), 114(U2+), 114(U2-), 114(V1+), 114(V1-), 114(V2+), 114(V2-), 114(W1+), 114(W1-), 114(W2+) and 114(W2-) are wound respectively over the teeth 112T(U1+), ..., 112T(W2-) in the concentrated winding way.

Here, the stator coil 114(U1+) and the stator coil 114(U1-) are wound such that the directions of currents flowing through those coils are opposite to each other.
Also, the stator coil 114(U2+) and the stator coil 114(U2-) are wound such that the directions of currents flowing through those coils are opposite to each other. Further, the stator coil 114(U1+) and the stator coil 114(U2+) are wound such that the directions of currents flowing through those coils are the same. The stator coil 114(U1-) and the stator coil 114(U2-) are wound such that the directions of currents flowing through those coils are the same. The relationships of the directions in which currents flow through the stator coils 114(V1+), 114(V1-), 114(V2+) and 114(V2-), and the relationships of the directions in which currents flow through the stator coils 114(W1+), 114(W1-), 114(W2+) and 114(W2-) are the same as those for the stator coils of the U-phase.

Since twelve teeth 112T and twelve stator coils 114 are manufactured in the same manner, assembly steps of the tooth 112T(U1+) and the stator coil 114(U1+) will be described below by way of example. The stator coil 114(U1+) is a formed coil that is previously formed into a shape resulting when it is wound over the tooth 112T(U1+). The stator coil 114(U1+) prepared as the formed coil is formed together with a bobbin 112BO. An integral member of the stator coil 114(U1+) and the bobbin 112BO formed together is fitted over the tooth 112T(U1+) from the back end side thereof. Because a fore end of the tooth 112T(U1+), i.e., an end of the tooth 112T(U1+) on the side facing the rotor 130, is expanded in the circumferential direction, the expanded portion serves as a stopper to hold the bobbin 112BO and the stator coil 114(U1+) in place. A projection 112TT capable of engaging in a recess 112BK formed in an inner periphery of the back core 112B is formed at the back end of the tooth 112T(U1+). The tooth 112T(U1+) is fixed to the back core 112B by press-fitting the projection 112TT of the tooth 112T(U1+), over which the formed stator coil 114(U1+) is wound, into the recess 112BK of the back core 112B. Steps of mounting the other stator coils 114(U1-), ..., 114(W2-) to the corresponding teeth 112T(U1-), ..., 112T(W2-), and steps of fixing the teeth 112T(U1-), ..., 112T(W2-) to the back core 112B are the same as those described above.

In a state where the twelve teeth 112T mounted with the stator coils 114 are fixed to the back core 112B and the back core 112B is press-fitted at plural points on the outer periphery thereof into the inner periphery of the frame 150, the stator core 112 and the stator coils 114 are integrally molded with a thermosetting resin MR to constitute the stator SubAssy. The embodiment has been described in connection with the case of integrally molding the stator core 112 and the stator coils 114 with the resin in the state where the assembly obtained by assembling the stator coils 114 in the stator core 112 is press-fitted into the frame 150. As an alternative, the stator core 112 and the stator coils 114 may be integrally molded with the resin in the state where the stator coils 114 are assembled in the stator core 112, followed by press-fitting the stator core 112 into the frame 150.

The molding process using a molding material (resin) is carried out as follows. A jig (not shown) is mounted to a structure comprising the stator core 112 and the frame 150 such that the stator core 112 and the coil ends of the stator coils 114 axially projecting from the axial ends of the stator core 112 are surrounded by the jig (not shown) and the frame 150. The molding material in a fluid state is poured into a space surrounded by the jig (not shown) and the frame 150, causing the molding material to fill into areas around the coil ends, gaps in the stator core 112, gaps in the stator coils 114, gaps between the stator core 112 and the stator coils 114, and a gap between the stator core 112 and the frame 150. The molding material is then hardened. After the molding material has been hardened, the jig (not shown) is removed.

An inner peripheral surface of the molded stator SubAssy, i.e., fore end surfaces of the teeth 112T(U1-), ..., 112T(W2-) positioned to radially face the rotor 130, are subjected to cutting. The cutting reduces variations of the gap between the stator 110 and the rotor 130 and improves the roundness of the stator 110 at the inner diameter. Also, the above-described integral molding is able to increase release of heat generated upon supply of currents to the stator coils 114 in comparison with the case of not performing the integral molding. In addition, the integral molding is able to prevent vibrations of the stator coils and the teeth.

For example, assuming the gap between the outer periphery of the rotor core of the rotor 130 and the inner peripheries of the teeth of the stator 110 to be 3 mm (3000 µm), the stator roundness at the inner diameter is about ± 30 µm due to a manufacturing error of the back core 112B, manufacturing errors of the teeth 112T, assembly errors caused in press-fitting assembly of the back core 112B and the teeth 112T, etc. Because such a value of the roundness corresponds to 1% (= 30 µm/3000 µm) of the gap, cogging torque is generated attributable to the stator roundness at the inner diameter. By cutting the inner periphery of the stator after the molding process, however, the cogging torque attributable to the stator roundness at the inner diameter can be reduced. The reduced cogging torque improves a steering feel in the steering operation.

Projections 150T are formed on the inner peripheral surface of the frame 150. Recesses 112BO2 are formed in the outer peripheral surface of the back core 112B corresponding to the projections 150T, as shown in detail in Fig. 8B.
Each projection 150T and each recess 112B02 define an interface portion IP where the projection 150T and the recess 112BO2 having different curvatures engage with each other. Eight projections 150T and eight recesses 112BO2 are formed continuously in the axial direction at angular intervals in the circumferential direction. The interface portion IP serves also as a press-fitting portion. In other words, when the stator core 112 is fixed to the frame 150, the recesses 112BO2 of the back core 112B are press-fitted to the projections 150T of the frame 150 such that projected end surfaces of the projections 150T and bottom surfaces of the recesses 112B02 are held in contact pressure with each other in the interface portions. Thus, in the embodiment, the stator core 112 is fixed to the frame 150 by partial press fitting. With the partial press fitting, a small gap is formed between the frame 150 and the stator core 112. In the embodiment, therefore, when the stator core 112 and the stator coils 114 are molded with a molding material (resin) MR, the molding material MR is filled into the small gap between the frame 150 and the stator core 112 at the same time. Additionally, the interface portions IP serve as rotation stoppers for preventing the stator core 112 from rotating relative to the frame 150 in the circumferential direction.

As described above, in the embodiment, since the stator core 112 is partially press-fitted to the frame 150, it is possible to increase slippage between the frame 150 and the stator core 112, and to reduce the rigidity. As a result, the embodiment can increase the effect of attenuating noises caused between the frame 150 and the stator core 112. Further, in the embodiment, since the molding material is filled in the gap between the frame 150 and the stator core 112, the effect of attenuating noises is further increased.

Alternatively, the projections 150T and the recesses 112BO2 may be held not contact with each other to serve only as the rotation stoppers, while the outer peripheral surface of the back core 112B may be press-fitted to the inner peripheral surface of the frame 150 in portions other than the projections 150T and the recesses 112BO2.

Further, the stator coils 114(U1+), 114(U1-) and the stator coils 114(U2+), 114(U2-) are arranged in symmetrical positions about the center of the stator 110. Also, the stator coils 114(U1+), 114(U1-) are arranged adjacent to each other, and the stator coils 114(U2+), 114(U2-) are arranged adjacent to each other. Further, the stator coils 114(U1+), 114(U1-) and the stator coils 114(U2+), 114(U2-) are arranged in line symmetrical relation about the center of the stator 110. In other words, with respect to a broken line C-C passing the center of the shaft 138, the stator coil 114(U1+) and the stator coil 114(U2+) are arranged in line symmetrical relation, and the stator coil 114(U1-) and the stator coil 114(U2-) are arranged in line symmetrical relation.

Similarly, the stator coils 114(V1+), 114(V1-) are arranged in line symmetrical relation to the stator coils 114(V2+), 114(V2-), and the stator coils 114(W1+), 114(W1-) are arranged in line symmetrical relation to the stator coils 114(W2+), 114(W2-).

The two adjacent stator coils 114 of the same phase are formed by continuously winding a single wire. For example, the stator coils 114(U1+), 114(U1-) are formed by continuously winding a single wire to constitute two coils and fitting the two coils over one tooth in winding relation to the tooth. The stator coils 114(U2+), 114(U2-) are also formed by continuously winding a single wire. Similarly, respective pairs of the stator coils 114(V1+), 114(V1-), the stator coils 114(V2+), 114(V2-), the stator coils 114(W1+), 114(W1-), and the stator coils 114(W2+), 114(W2-) are each formed by continuously winding a single wire.

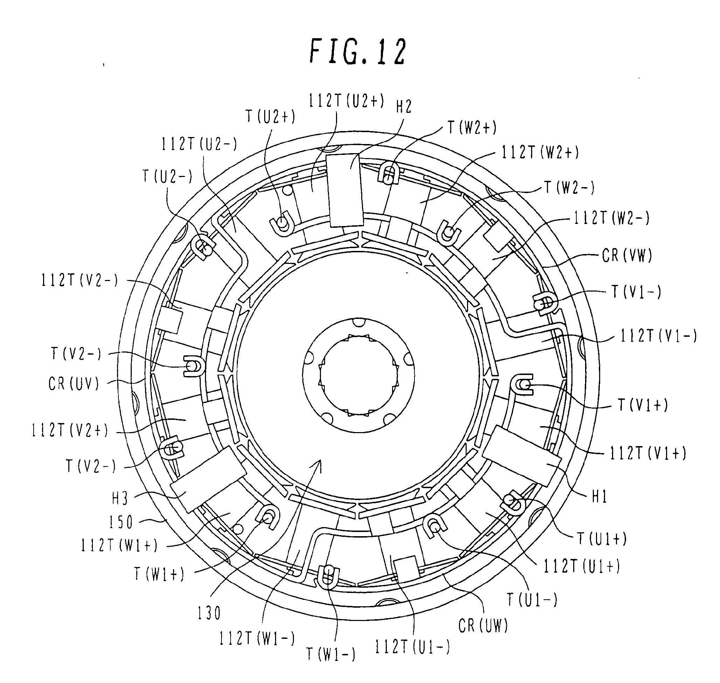

By thus arranging the corresponding stator coils in line symmetrical relation and forming the two adjacent stator coils of the same phase by winding a single wire, the arrangement of the connecting rings can be simplified, as described later with reference to Fig. 12, when the stator coils of the same phase or the different phases are interconnected by the connecting rings.

The rotor 130 comprises a rotor core 132 made of a magnetic substance, ten magnets 134 (134A, 134B, 134C, 134D, 134E, 134F, 134G, 134H, 134I and 134J) fixed to the surface of the rotor core 132 by an adhesive, and a magnet cover 136 disposed around the magnets 134. The rotor core 132 is fixed to the shaft 138.

One half of the magnets 134 are each radially magnetized such that, when the surface side (side positioned to face the stator tooth 112T) is magnetized to an N pole, the rear side (side bonded to the rotor core 132) is magnetized to an S pole. The other half of the magnets 134 are each radially magnetized such that, when the surface side (side positioned to face the stator tooth 112T) is magnetized to an S pole, the rear side (side bonded to the rotor core 132) is magnetized to an N pole. Then, the adjacent magnets 134 are magnetized such that the magnetized poles are alternately arranged in the circumferential direction. For example, when the surface side of the magnet 134A is magnetized to an N pole, the surface sides of the adjacent magnets 134B, 134J are each magnetized to an S pole. In such a way, when the surface sides of the magnets 134A, 134C, 134E, 134G and 134I are magnetized to N poles, the surface sides of the magnets 134B, 134D, 134F, 134H and 134J are magnetized to S poles.

Each of the magnets 134 has a semi-cylindrical shape in cross-section. The term "semi-cylindrical shape" means a structure that, looking at the magnet in the circumferential direction, left and right portions have a smaller radial thickness than a central portion. By forming the magnet into such a semi-cylindrical shape, magnetic flux can be produced in sinusoidal distribution. Therefore, a voltage can be induced in sinusoidal waveform with the rotation of the EPS motor, and pulsations can be reduced. The reduction of pulsations improves a steering feel in the steering operation. Additionally, when the magnets are formed by magnetizing a ring-shaped magnetic substance, a sinusoidal or similar distribution of magnetic flux may be obtained with control of magnetization forces.

The rotor core 132 has ten through holes 132H having a relatively large diameter and formed in concentric relation, and five dents 132K having a relatively small diameter and formed in the inner peripheral side of the through holes 132H. The rotor core 132 is fabricated by punching sheets made of a magnetic substance, e.g., SUS, by pressing, and then laminating the punched sheets in multiple layers. The dents 132K are formed by embossing the sheet in the pressing step. When a plurality of sheets are laminated in multiple layers, the corresponding dents 132K are engaged with each other for proper positioning. The through holes 132H serve to reduce the inertia, and the presence of the through holes 132H contributes to improving balance of the rotor. The outer peripheral side of the magnets 134 is covered with the magnet cover 136 so that the magnets 134 are prevented from scattering away. Additionally, the back core 112B and the rotor core 132 are formed at the same time by punching of the same sheet.

As described above, the rotor 130 in the embodiment has ten magnets 134 and hence has 10 poles. Also, there are twelve teeth 112T, and the number of slots defined between the adjacent teeth is 12. Thus, the EPS motor 100 according to the embodiment is a synchronous motor of the surface magnet type having 10 poles and 12 slots.

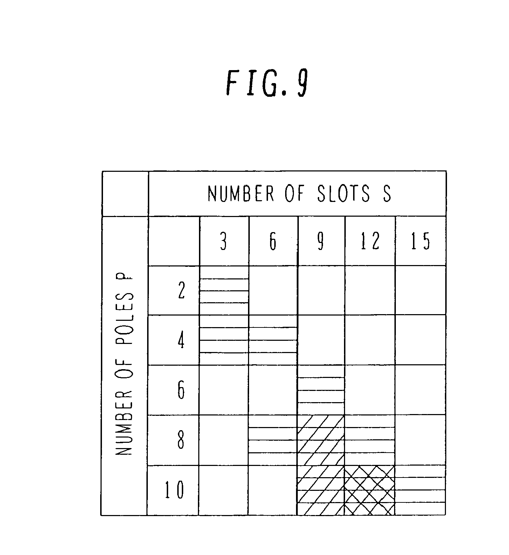

The relationship between the number of poles P and the number of slots S in an AC motor will be described with reference to Fig. 9.

In Fig. 9, horizontally hatched boxes represent combinations of the number of poles P and the number of slots S, which are usable in a 3-phase AC motor (brushless motor). More specifically, the 3-phase AC motor can be constituted as one of combinations of 2 poles - 3 slots, 4 poles - 3 slots, 4 poles - 6 slots, 6 poles - 9 slots, 8 poles - 6 slots, 8 poles - 9 slots, 8 poles - 12 slots, 10 poles - 9 slots, 10 poles - 12 slots, and 10 poles - 15 slots. Among them, the combination of 10 poles and 12 slots represented by both ascent and descent oblique hatch lines corresponds to the number of poles and the number of slots in the motor according to the embodiment. The combination of 8 poles - 9 slots and 10 poles - 9 slots represented by ascent oblique hatch lines will be described later. Note that combinations with the number of poles P being 12 or more are not shown in Fig. 9 because the EPS motor 100 shown in Fig. 1 is a small-sized motor having an outer diameter of 85 mm and the number of poles P being 12 or more cannot be realized in such a small-sized motor.

Since motors in the combinations of 2 poles - 3 slots, 4 poles - 3 slots, 4 poles - 6 slots, 6 poles - 9 slots, 8 poles - 6 slots, 8 poles - 12 slots, and 10 poles - 15 slots have similar characteristics, the following description is made by taking the motor of 6 poles and 9 slots as a typical example.

As compared with the AC motor of 6 poles and 9 slots, a higher utilization factor of magnetic flux can be obtained with the motor of 10 poles and 12 slots according to the embodiment. More specifically, because the AC motor of 6 poles and 9 slots has a winding coefficient (winding utilization factor) kw of 0.87 and a skew coefficient ks of 0.96, the utilization factor (kw·ks) of the magnet-producing magnetic flux is "0.83". On the other hand, because the motor of 10 poles and 12 slots according to the embodiment has a winding coefficient kw of 0.93 and a skew coefficient ks of 0.99, the utilization factor (kw·ks) of the magnet-producing magnetic flux is "0.92". Thus, the motor of 10 poles and 12 slots according to the embodiment can increase the utilization factor (kw·ks) of the magnet-producing magnetic flux.

Also, since the cycle of cogging torque is given by the least common multiple of the number of poles P and the number of slots S, the cycle of cogging torque is "18" in the AC motor of 6 poles and 9 slots is "18", while it is "60" in the motor of 10 poles and 12 slots according to the embodiment. As a result, the cogging torque can be reduced in the motor of the embodiment.

Further, the cogging torque caused by errors in the stator roundness at the inner diameter can be reduced. More specifically, when the cogging torque caused by errors in the stator roundness at the inner diameter is assumed to be "3.7" in the AC motor of 6 poles and 9 slots, it is "2.4" in the motor of 10 poles and 12 slots according to the embodiment. As a result, the motor of the embodiment can reduce the cogging torque caused by errors in the stator roundness at the inner diameter. Moreover, in the embodiment, since the stator roundness at the inner diameter is improved by cutting the inner peripheral surface of the molded stator SubAssy, it is possible to further reduce the cogging torque caused by errors in the stator roundness at the inner diameter.

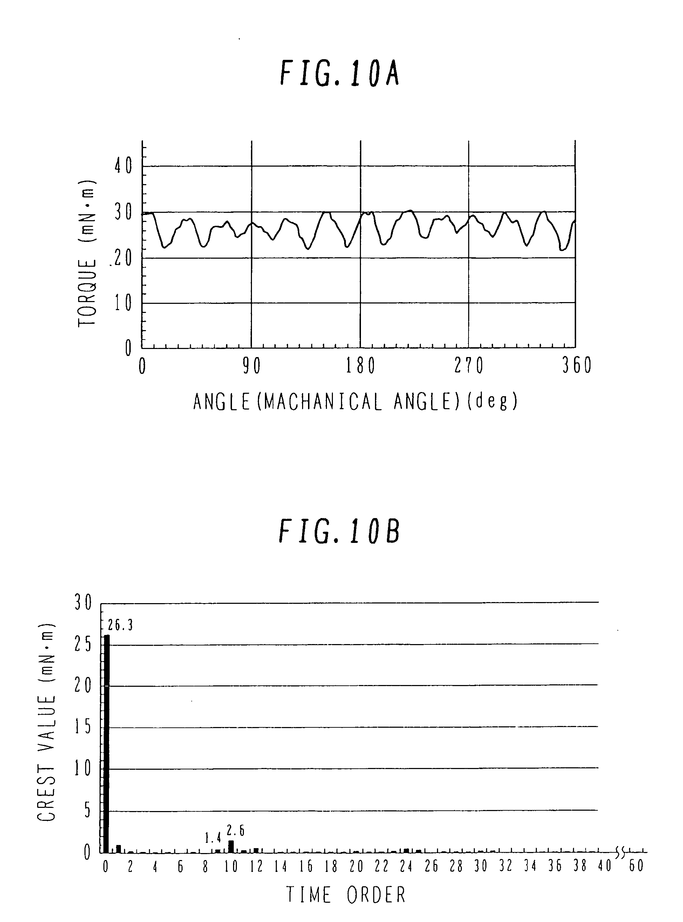

The measured values of cogging torque of the electric power steering motor according to the embodiment will be described below with reference to Fig. 10.

Fig. 10A shows the cogging torque (mNm) actually measured in the range of angle (mechanical angle) from 0 to 360°, and Fig. 10B shows the crest value (mNm) resulting when higher harmonic components of the cogging torque shown in Fig. 10A are separated into respective time orders.

The time order "60" represents the above-mentioned cycle of cogging torque in the motor of 10 poles and 12 slots, and the cogging torque generated at the time order "60" is substantially 0. The time order "12" represents the cogging torque due to variations in field forces of the magnets having 10 poles. By using a semi-cylindrical magnet as each of the magnets in the embodiment as described above, the cogging torque due to variations in field forces can also be reduced to 1.4. The time order "10" represents the cogging torque due to variations in the teeth of the stator having 12 slots. As a result of improving the stator roundness at the inner diameter by cutting after the molding step, the cogging torque due to variations in the teeth can also be reduced to 2.6.

The time order "0" represents a DC component, i.e., the so-called loss torque (frictional torque generated when the rotation speed is substantially zero). As seen, the loss torque is reduced to 26.3 mNm. Therefore, returnability of the steering wheel is increased even when the driver releases the steering wheel from the hands, because the loss torque is smaller than the restoring force causing the steering wheel to return toward the straight-forwarding direction.

As a result of the above-mentioned reductions in the respective cogging torque components, as shown in Fig. 10A, the cogging torque can be reduced to 9 mNm. Since the maximum torque of the EPS motor is 4.5 Nm, the cogging torque is reduced to 0.2% (= 9 mNm / 4.5 Nm) (namely, not larger than 3/1000 of the rated value). In addition, the loss torque is also reduced to 0.57% (= 26.3 mNm / 4.5 Nm).

In the adjacent teeth 112T, a spacing W1 between the expanded portions of the fore ends of those teeth 112T (e.g., a spacing W1 between the expanded portions of the fore ends of the tooth 112T(U1-) and the tooth 112T(W1-) (namely, a circumferential spacing between respective portions of those teeth which are closest to each other in the circumferential direction)) is set to 1 mm. By thus narrowing the spacing between the teeth, the cogging torque can be reduced. Further, even with vibrations applied to the motor, the stator coil 114 can be prevented from slipping off toward the rotor side through the spacing between the adjacent teeth because the wire diameter of the stator coil 114 is larger than the spacing W1. The spacing W1 between the adjacent teeth is preferably set to, e.g., the range of 0.5 mm - 1.5 mm smaller than the wire diameter of the stator coil 114. Thus, in the embodiment, the spacing W1 between the adjacent teeth is set smaller than the wire diameter of the stator coil 114.

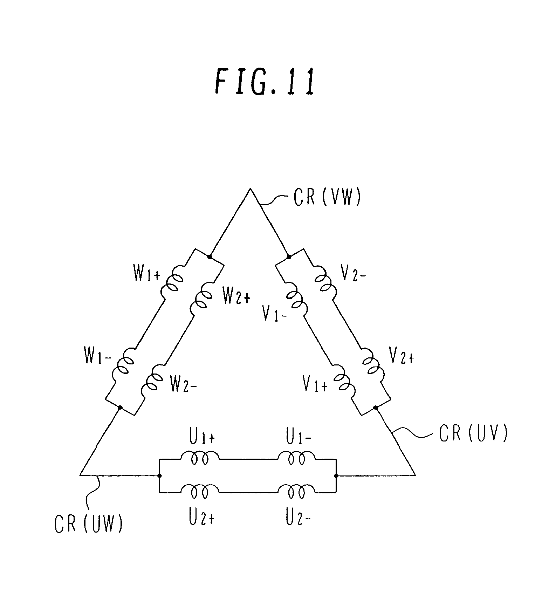

Fig. 11 shows the connection relationship of the stator coils in the electric power steering motor of the embodiment, and Fig. 12 shows the connection state of the stator coils of the electric power steering motor of the embodiment.

In Fig. 11, a coil U1+ represents the stator coil 114(U1+) shown in Fig. 8. Likewise, coils U1-, U2+, U2-, V1+, V1-, V2+, V2-, W1+, W1-, W2+ and W2- represents the stator coil 114(U1-), ..., 114(W2-) shown in Fig. 8, respectively.

In the embodiment, the stator coils of the U-, V- and W-phases are interconnected in delta (Δ) connection. Also, the stator coils of each phase constitute a parallel circuit. Looking at the U-phase in more detail, a serial circuit of the coil U1+ and the coil U1- is connected in parallel to a serial circuit of the coil U2+ and the coil U2-. Here, the coil U1+ and the coil U1- are formed, as described above, by continuously winding a single wire. The other stator coils of the V- and W-phases are also connected in a similar way.

While star connection is also usable as another connection method, the delta connection is advantageous in reducing the terminal voltage as compared with the star connection. Assuming the voltage across the serial-parallel circuit of the U-phase to be E, for example, the terminal voltage is E in the case of the delta connection, but it is √3E in the case of the star connection. With a reduction of the terminal voltage, the number of turns of each coil can be increased and a wire having a smaller diameter can be used. Further, because of the coils constituting the parallel circuit, a current flowing through each coil can be reduced in comparison with the case of connecting four coils in series. From this point of view as well, a wire having a smaller diameter can be used and an area occupancy rate can be increased. In addition, a thinner wire is more easily bendable and higher manufacturability is realized.

As shown in Fig. 11, the coils U1-, U2- and the coils V1+, V2+ are connected to each other by a connecting ring CR(UV). The coils V1-, V2- and the coils W1+, W2+ are connected to each other by a connecting ring CR(VW). The coils U1+, U2+ and the coils W1-, W2- are connected to each other by a connecting ring CR(UW). By connecting the coils in such a manner, the 3-phase delta connection can be constituted.

More specifically, the three connecting rings CR(UV), CR(VW) and CR(UW) are arranged as shown in Fig. 12. The connecting rings CR(UV), CR(VW) and CR(UW) are formed by bending a bus-bar type connecting plate into a circular-arc shape so that a large current is allowed to flow through each connecting ring. The connecting rings have the same shape. For example, the connecting ring CR(UV) has a shape resulting from connecting a circular arc having a small diameter and a circular arc having a large diameter to each other. The other connecting rings CR(VW), CR(UW) are also constituted in the same way. The connecting rings CR(UV), CR(VW) and CR(UW) are held respectively by holders H1, H2 and H3 at angular intervals of 120° in the circumferential direction. The connecting rings CR and the holders H1, H2 and H3 are molded with a molding material together with the coil ends.

In Fig. 12, a stator coil end T(U1+) is one end of the stator coil 114(U1+) wound over the tooth 112T(U1+). A stator coil end T(U1-) is one end of the stator coil 114 (U1-) wound over the tooth 112T(U1-). Because the stator coil 114(U1+) and the stator coil 114(U1-) are formed by continuously winding a single wire as described above, the two stator coil ends T(U1+), T(U1-) are present for the two stator coils 114(U1+), 114(U1-). Similarly, stator coil ends T(U2+), T(U2-), T(V1+), T(V1-), T(V2+), T(V2-), T(W1+), T(W1-), T(W2+) and T(W2-) are respective one ends of the stator coil 114 (U2+), ..., 114 (W2+).

The stator coil ends T(U1-), T(U2-), T(V1+) and T(V2+) are interconnected by the connecting ring CR(UV), thereby establishing the connection between the coils U1-, U2- and the coils V1+, V2+ through the connecting ring CR(UV) as shown in Fig. 11. The stator coil ends T(V1-), T(V2-), T(W1+) and T(W2+) are interconnected by the connecting ring CR(VW), thereby establishing the connection between the coils V1-, V2- and the coils W1+, W2+ through the connecting ring CR(VW) as shown in Fig. 11. The stator coil ends T(W1-), T(W2-), T(U1+) and T(U2+) are interconnected by the connecting ring CR(UW), thereby establishing the connection between the coils U1+, U2+ and the coils W1-, W2- through the connecting ring CR(UW) as shown in Fig. 11.

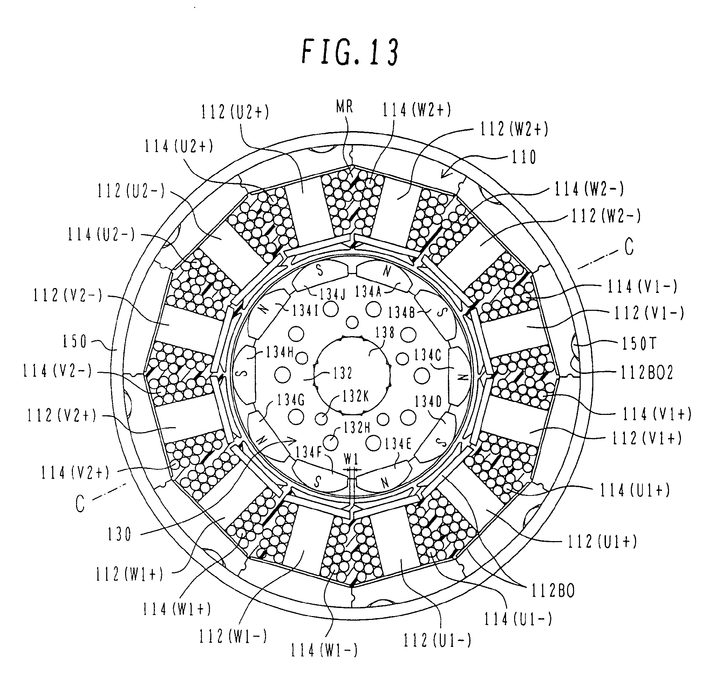

Fig. 13 shows another example of the structure of the stator 110 of the EPS motor used in the EPS system according to the embodiment. The same reference numerals as those in Fig. 8 denote the same components.

In the stator 110 shown in Fig. 8, the stator core 112 is made up of the annular back core 112B and the plurality of teeth 112T separate from the back core 112B. In contrast, the stator core 112 in this example is made up of twelve T-shaped teeth-including split back cores 112B(U1+), 112B(U1-), 112B(U2+), 112B(U2-), 112B(V1+), 112B(V1-), 112B(V2+), 112B(V2-), 112B(W1+), 112B(W1-), 112B(W2+) and 112B(W2-). Stated another way, the annular back core 112B in Fig. 8 is split into 12 pieces in the circumferential direction. Then, a tooth is formed integrally with each of the split back cores. The teeth-including split back cores 112B(U1+), ..., 112B(W2-) are each fabricated by punching sheets made of a magnetic substance, e.g., silicon steel sheets, by pressing, and then laminating the punched sheets in multiple layers. Additionally, a rotor 130 has the same structure as that shown in Fig. 8.

In teeth portions of the teeth-including split back cores 112B(U1+), ..., 112B(W2-), as in Fig. 8, stator coils 114(U1+), 114(U1-), 114(U2+), 114(U2-), 114(V1+), 114(V1-), 114(V2+), 114(V2-), 114(W1+), 114(W1-), 114(W2+) and 114(W2-) are wound respectively over twelve independent teeth 112T(U1+), ..., 112T(W2-) in a concentrated winding way. The winding direction, etc. of the stator coils 114(U1+), ..., 114(W2-) are the same as those in Fig. 8.

The stator is fabricated as follows. The stator coils 114(U1+), ..., 114(W2-) are wound respective over the teeth-including split back cores 112B(U1+), ..., 112B(W2-). Then, recesses and projections, which are engageable with each other and formed in circumferential opposite end surfaces of each of the teeth-including split back cores 112B(U1+), ..., 112B(W2-), are press-fitted in a successive manner, whereby the stator 110 is assembled. Subsequently, in a state where the back core 112B is press-fitted at plural points on the outer periphery thereof into the inner periphery of the frame 150, the stator core 112 and the stator coils 114 are integrally molded with a thermosetting resin MR to constitute a stator SubAssy. While, in this example, the stator core 112 and the stator coils 114 are integrally molded with the resin in the state where the assembly obtained by assembling the stator coils 114 in the stator core 112 is press-fitted into the frame 150, the stator core 112 and the stator coils 114 may be integrally molded with the resin in the state where the stator coils 114 are assembled in the stator core 112, followed by press-fitting the stator core 112 into the frame 150.

The molding process using a molding material (resin) is carried out as follows. A jig (not shown) is mounted to a structure comprising the stator core 112 and the frame 150 such that the stator core 112 and the coil ends of the stator coils 114 axially projecting from the axial ends of the stator core 112 are surrounded by the jig (not shown) and the frame 150. The molding material in a fluid state is poured into a space surrounded by the jig (not shown) and the frame 150, causing the molding material to fill into areas around the coil ends, gaps in the stator core 112, gaps in the stator coils 114, gaps between the stator core 112 and the stator coils 114, and a gap between the stator core 112 and the frame 150. The molding material is then hardened. After the molding material has been hardened, the jig (not shown) is removed.

An inner peripheral surface of the molded stator SubAssy, i.e., fore end surfaces of the teeth portions of the teeth-including split back cores 112B(U1+), ..., 112B(W2-) which are positioned to radially face the rotor 130, are subjected to cutting. The cutting reduces variations of the gap between the stator 110 and the rotor 130 and improves the roundness of the stator 110 at the inner diameter. Also, the above-described integral molding is able to increase release of heat generated upon supply of currents to the stator coils 114 in comparison with the case not performing the integral molding. Further, the integral molding is able to prevent vibrations of the stator coils and the teeth. In addition, by cutting the inner periphery of the stator after the molding process, the cogging torque attributable to the stator roundness at the inner diameter can be reduced. The reduced cogging torque improves a steering feel in the steering operation.

Projections 150T are formed on the inner peripheral surface of the frame 150. Recesses 112BO2 are formed in the outer peripheral surface of the back core 112B corresponding to the projections 150T. As described above with reference to Fig. 8B, each projection 150T and each recess 112BO2 define an interface portion IP where the projection 150T and the recess 112BO2 having different curvatures engage with each other. Each number 8 of projections 150T and the recesses 112BO2 are formed continuously in the axial direction at angular intervals in the circumferential direction. The interface portion IP serves also as a press-fitting portion. In other words, when the stator core 112 is fixed to the frame 150, the recesses 112BO2 of the back core 112B are press-fitted to the projections 150T of the frame 150 such that projected end surfaces of the projections 150T and bottom surfaces of the recesses 112BO2 are held in contact pressure with each other in the interface portions. Thus, in the embodiment, the stator core 112 is fixed to the frame 150 by partial press fitting. With the partial press fitting, a small gap is formed between the frame 150 and the stator core 112. In the embodiment, therefore, when the stator core 112 and the stator coils 114 are molded with a molding material (resin) MR, the molding material MR is filled into the small gap between the frame 150 and the stator core 112 at the same time. Additionally, the interface portions IP serve as rotation stoppers for preventing the stator core 112 from rotating relative to the frame 150 in the circumferential direction.

As described above, in the embodiment, since the stator core 112 is partially press-fitted to the frame 150, it is possible to increase slippage between the frame 150 and the stator core 112, and to reduce the rigidity. As a result, the embodiment can increase the effect of attenuating noises caused between the frame 150 and the stator core 112.
Further, in the embodiment, since the molding material is filled in the gap between the frame 150 and the stator core 112, the effect of attenuating noises is further increased.

Alternatively, the projections 150T and the recesses 112BO2 may be held not contact with each other to serve only as the rotation stoppers, while the outer peripheral surface of the back core 112B may be press-fitted to the inner peripheral surface of the frame 150 in portions other than the projections 150T and the recesses 112BO2.

The above description was made of the EPS motor of 10 poles and 12 slots. The following description is made of the EPS motors of 8 poles - 9 slots and 10 poles - 9 slots according to the embodiment, which are indicated by the oblique hatches in Fig. 9.

As compared with the AC motor of 6 poles and 9 slots, a higher utilization factor of magnetic flux can be obtained with the motors of 8 poles - 9 slots and 10 poles - 9 slots. More specifically, the utilization factor (kw·ks) of the magnet-producing magnetic flux in the AC motor of 6 poles and 9 slots is "0.83" as described above. On the other hand, because the motors of 8 poles - 9 slots and 10 poles - 9 slots have a winding coefficient kw of 0.95 and a skew coefficient ks of 1.00, the utilization factor (kw·ks) of the magnet-producing magnetic flux is "0.94". Thus, the motors of 8 poles - 9 slots and 10 poles - 9 slots according to the embodiment can increase the utilization factor (kw·ks) of the magnet-producing magnetic flux.

Also, the cycle of cogging torque is given by the least common multiple of the number of poles P and the number of slots S. Therefore, the cycle of cogging torque is "18" in the AC motor of 6 poles and 9 slots, while it is "72" or more in the motors of 8 poles - 9 slots and 10 poles - 9 slots. As a result, the cogging torque can be reduced in the motors of the embodiment.

Further, the cogging torque caused by errors in the stator roundness at the inner diameter can be reduced. More specifically, when the cogging torque caused by errors in the stator roundness at the inner diameter is assumed to be "3.7" in the AC motor of 6 poles and 9 slots, it is "1.4" in the motors of 8 poles - 9 slots and 10 poles - 9 slots. As a result, the motors of the embodiment can reduce the cogging torque caused by errors in the stator roundness at the inner diameter. Moreover, in the embodiment, since the stator roundness at the inner diameter is improved by cutting the inner peripheral surface of the molded stator SubAssy, it is possible to further reduce the cogging torque caused by errors in the stator roundness at the inner diameter.

Incidentally, in the motors of 8 poles - 9 slots and 10 poles - 9 slots, the circuit arrangement has to be modified. Looking at the U-phase, for example, those motors cannot employ parallel connection of the serial circuit of the coils U1+, U1- and the serial circuit of the coils U2+, U2-as in the EPS motor of 10 poles and 12 slots described above with reference to Fig. 11. Therefore, the coils U1+, U1-, U2+ and U2- must be connected in series.

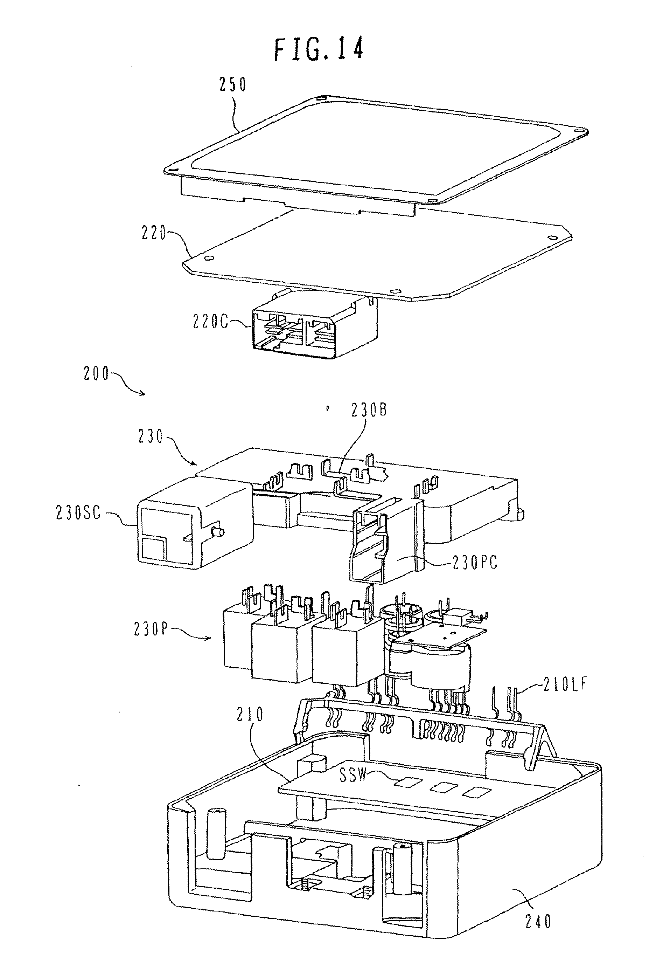

The control unit (inverter) used in the EPS system of the embodiment will be described below with reference to Figs. 14-21.

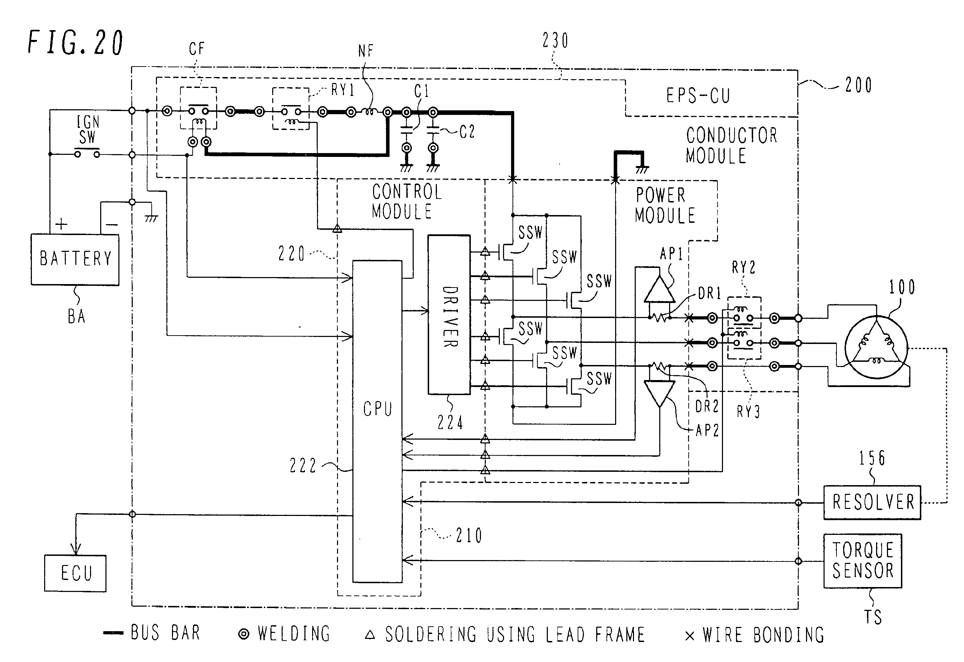

Fig. 20 shows the circuit configuration of the control unit (inverter) used in the EPS system of the embodiment.

A motor control unit 200 comprises a power module 210, a control module 220, and a conductor module 230.

The conductor module 230 includes bus bars 230B (see Fig. 14) that are integrally molded and serve as power lines. In Fig. 20, thick solid lines represent the bus bars. In the conductor module 230, as shown, a common filter CF, a normal filter NF, ceramic capacitors CC1, CC2, and a relay RY1 are connected to the bus bars that connect a battery BA, i.e., a power supply, to the collector terminals of semiconductor switching devices SSW, e.g., IGBTs, in the power module 210.

Also, a double circle in Fig. 20 represents a portion connected by welding. For example, four terminals of the common filter CF are connected to terminals of the bus bars by welding. Similarly, two terminals of the normal filter NF, two terminals of each of the ceramic capacitors CC1, CC2, and two terminals of the relay RY1 are connected to corresponding terminals of the bus bars by welding. The common filter CF and the normal filter NF serve to prevent radio noises.

Further, the bus bars are used in wiring to supply motor currents from the power module 210 to the motor 100. Relays RY2, RY3 are connected by welding to the wiring of the bus bars extended from the power module 210 to the motor 100. The relays RY1, RY2 and RY3 are disposed for the purpose of failsafe to cut off the supply of power to the motor in the event that an abnormality occurs in the motor, the control module, etc.

The control module 220 includes a CPU 222 and a driver circuit 224. The CPU 222 produces, based on the torque detected by the torque sensor TS and the rotational position of the motor 100 detected by the resolver 156, control signals for executing on/off control of the semiconductor switching devices SSW in the power module 210, and then outputs the control signals to the driver circuit 224. In accordance with the control signals supplied from the CPU 222, the driver circuit 224 performs on/off-driving of the semiconductor switching devices SSW in the power module 210. The motor currents supplied from the power module 210 to the motor 100 are detected by motor current detecting resistances (shunt resistances) DR1, DR2. The detected motor currents are amplified by amplifiers AP1, AP2 and are inputted to the CPU 222. The CPU 222 executes feedback control so that the motor currents are held at target values. The CPU 222 is connected to an external engine control unit ECU and so on via, e.g., a CAN (Controlled Area Network) or the like for transfer of information.

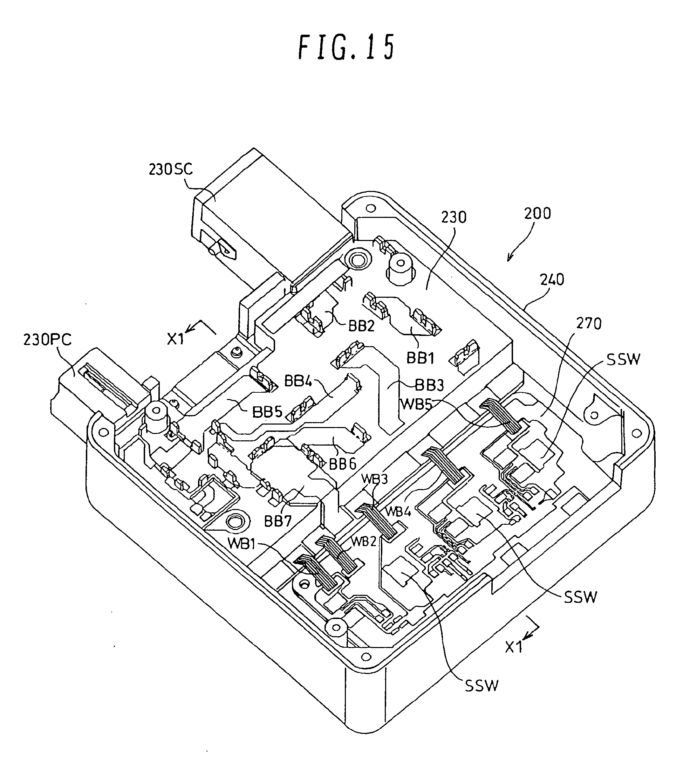

In Fig. 20, a mark Δ represents a portion connected by soldering using a lead frame. The use of the lead frame provides a structure capable of relieving stresses. The shape, etc. of the lead frame will be described below with reference to Fig. 15. Electrical connections of the control module 220 to the power module 210 or the conductor module 230 are established by soldering using the lead frames.

The power module 210 includes 6 semiconductor switching devices SSW, e.g., IGBTs. Three pairs of the semiconductor switching devices SSW are connected in series per pair for each of three phases (U-, V- and W-phases) to constitute upper and lower arms. In Fig. 20, a mark x represents a portion electrically connected by wire bonding. When the motor currents are supplied from the power module 210 to the motor 100 via the bus bars in the conductor module 230, those motor currents flow as a large current of, e.g., 100 A. The wire bonding is therefore employed as the structure capable of not only accommodating flow of the large current, but also relieving stresses. Details of the connected portions by the wire bonding will be described below with reference to Fig. 15. Source power supply lines and grounding lines are also connected to the semiconductor switching devices SSW by the wire bonding.

Figs. 14 and 15 show the overall structure of the control unit (inverter) used in the EPS system of the embodiment, i.e., the actual physical structure of the control unit in which the circuit configuration shown in Fig. 20 is practically formed.

As shown in Fig. 14, the motor control unit 200 comprises, in addition to the power module 210, the control module 220 and the conductor module 230, a casing 240 and a shield cover 250.

The power module 210 is constructed such that a wiring pattern is formed on a metallic board with insulators interposed between them and the semiconductor switching devices SSW, e.g., MOSFETs (Field Effect Transistors) described above with reference to Fig. 22, are mounted on the wiring pattern. Respective one ends of a plurality of lead frames 210LF are fixed to the power module 210 by soldering. The lead frames 210LF are used for electrical connection between the power module 210 and the control module 220.

The control module 220 is constructed such that the CPU, the driver circuit, etc. are mounted on a PCB board. In the illustrated state, the CPU, the driver circuit, etc. are mounted on the underside of the board. Further, a signal connector 220C is mounted to the control module 220.

The conductor module 230 includes the bus bars 230B that are integrally molded and serve as power lines. At the same time as the molding of the bus bars, a motor connector 230SC serving as a terminal for supplying the motor currents to the motor and a power supply connector 230PC supplied with power from the battery are also integrally molded. Further, parts 230P, such as relays, coils and capacitors, are mounted on the conductor module 230 in advance. Terminals of the parts 230P are connected to the bus bars 230B by TIG (Tungsten-Inert-Gas) welding (arc welding).

The casing 240 is made of aluminum. In assembly, the power module 210 and the conductor module 230 are fixed in the casing 240 by screwing. Then, the control module 220 is similarly fixed in the casing 240 by screwing at a position above the power module 210 and the conductor module 230. Then, the respective other ends of the lead frames 210LF are connected to the corresponding terminals of the control module 220 by soldering. Finally, the shield cover 250 is fixed in place by screwing, whereby the motor control unit 200 is manufactured.

As shown in Fig. 15, the conductor module 230 includes a plurality of bus bars BB1, BB2, BB3, BB4, BB5, BB6 and BB7 that are integrally molded. Terminals of these bus bars are connected by welding to the corresponding terminals of electrical parts, such as the common filter CF, the normal filter NF, the ceramic capacitors CC1, CC2, and the relays RY1, RY2 and RY3 described above with reference to Fig. 11.

The plurality of the semiconductor switching devices SSW are mounted in the power module 210. The power module 210 and the conductor module 230 are electrically connected to each other at five points by wire bodings WB1, WB2, WB3, WB4 and WB5. Looking at one wire bonding WB1, by way of example, the two modules are connected by arranging five aluminum wires in parallel, each wire having a diameter of, e.g., 500 µm.

The power module 210 and the conductor module 230 are arranged on the same plane in opposed relation. Stated another way, the power module 210 is arranged in the casing 240 at one side, and the conductor module 230 is arranged in the casing 240 at the other side. Accordingly, the wire bonding operation can be easily performed.

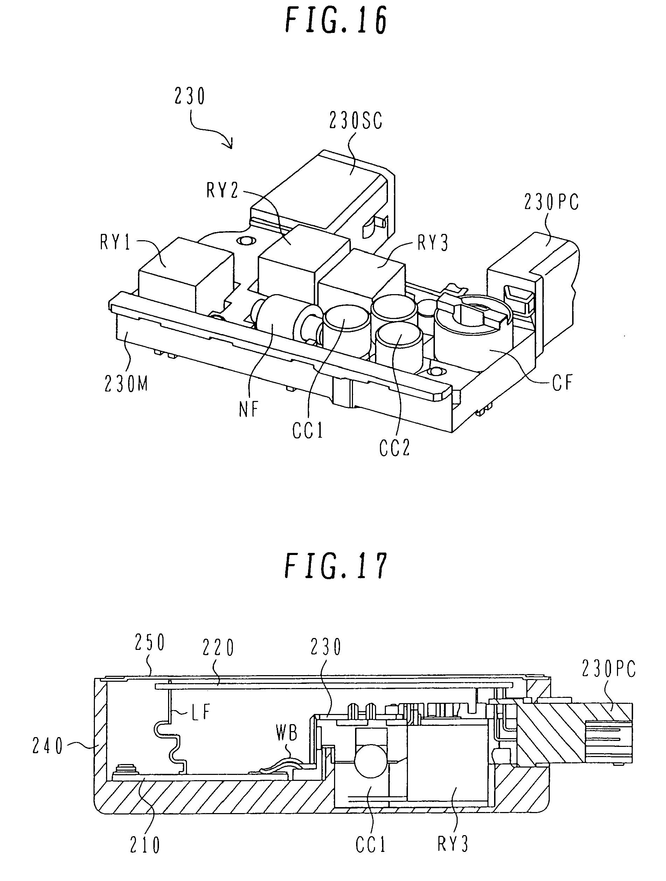

Fig. 16 shows the structure of the conductor module in the control unit used in the EPS system of the embodiment, as viewed from the bottom surface side.

The conductor module 230 is formed as a molded unit and has holes bored therein beforehand for insertion of the terminals of the electrical parts, such as the common filter CF, the normal filter NF, the ceramic capacitors CC1, CC2, and the relays RY1, RY2 and RY3. Those electrical parts are arranged in respective positions, and the terminals of the electrical parts are connected to the corresponding terminals of the bus bars by welding at the bottom surface side as viewed in Fig. 16.

Fig. 17 shows a section taken along the line X1-X1 in Fig. 15.

The power module 210 and the conductor module 230 are fixed to an inner bottom surface of the aluminum casing 240 by screwing. The conductor module 230 is fixedly screwed in the form of an integral module molded in a state where the electrical parts are arranged and connected to the bus bars by welding, as described above with reference to Fig. 20. Thereafter, the electrical connection between the power module 210 and the conductor module 230 is established by the wire bonding WB.

Lower ends of the lead frames LF are fixed to the power module 210 by soldering. In this state, the control module 220 is mounted above the power module 210 and upper ends of the lead frames LF are fixed to the corresponding terminals of the control module 220 by soldering. The control module 220 is fixed to the casing 240 by screwing. Then, the shield cover 250 is fixed to an upper end of the casing 240 by screwing.

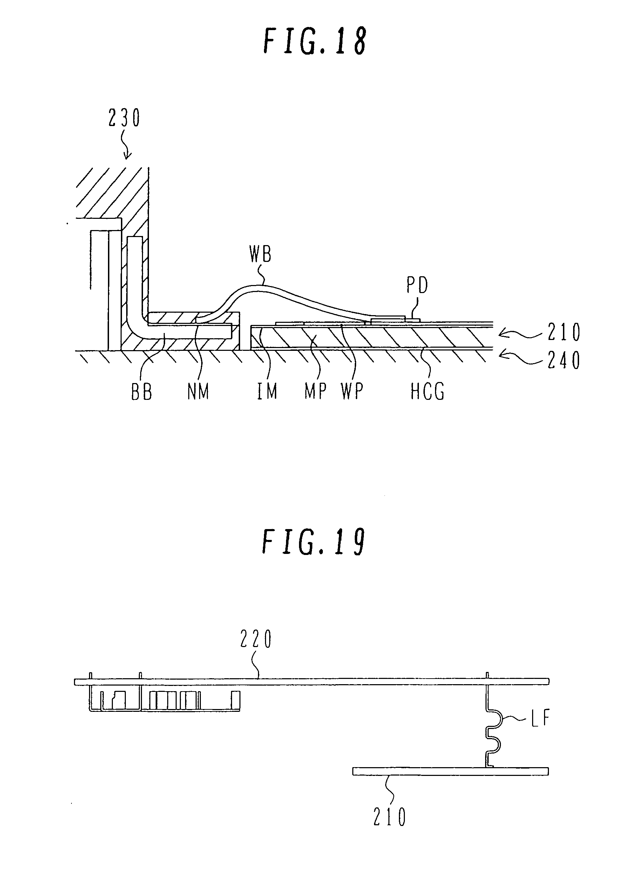

Fig. 18 shows the detailed structure of a connecting area between the power module and the conductor module.

Because the semiconductor switching devices SSW are mounted in the power module 210 and generate heat, the power module 210 is formed of a metallic board MP (using, e.g., aluminum (A1) or copper (Cu)) to release the generated heat. Heat conducting grease HCG is interposed between the metallic board MP and the casing 240 so that the heat generated by the semiconductor switching devices SSW are released from the aluminum casing 240 through the metallic board MP and the heat conducting grease HCG. On the metallic board MP, a wiring pattern WP is formed with an insulating film IM interposed between them. The insulating film IM is formed as a low-elastic insulating layer. The wiring pattern WP is formed by patterning a copper (Cu) foil with a thickness of 175 µm by etching. An aluminum pad PD used for electrical connection to the conductor module 230 is formed on the wiring pattern WP. The rear surface of the aluminum pad PD is coated with a film of nickel plating.

On the other hand, the conductor module 230 includes the integrally molded bus bar BB. The surface of an end portion of the bus bar BB, serving as a connecting portion to the power module 210, is coated with a film of nickel plating.

Then, the bus bar BB of the power module 210 and the aluminum pad PD of the conductor module 230 are connected to each other by the wire bonding WB using an aluminum wire.

Because the metallic board is used as a substrate of the conductor module 230 as described above, the conductor module 230 has a large coefficient of linear thermal expansion and repeats expansion and contraction with changes in temperature of the conductor module 230, thus causing stresses in its portion electrically connected to the power module 210. In consideration of that a large current (e.g., 100 A or larger) flows between the power module 210 and the conductor module 230, both the modules are preferably connected to each other by using a conductor, such as a bus bar. However, the use of the conductor gives rise to a risk that the electrically connected portion may peel off due to thermal stresses. To cope with the risk, the embodiment uses an aluminum wire that is apt to deform in a reversible manner. Since thermal deformations of the conductor module 230 are absorbed by the aluminum wire, the thermal stresses can be prevented from being applied to the electrically connected portion, and the stress-free connection can be realized. Additionally, in order to allow flow of the large current, five aluminum wires each having a diameter of 500 µm, for example, are connected in parallel.

The wiring pattern is formed by patterning a copper (Cu) foil with a thickness of 175 µm by etching for the reason that using a copper foil with a thickness in the range of 105 µm - 200 µm is effective in reducing the resistance value and lessening the amount of heat generated with the flow of the large current. Preferably, the thickness of the wiring pattern is set to the range of 145 µm - 175 µm. By setting the thickness of the wiring pattern to be not smaller than 145 µm, the resistance value and the amount of heat generated with the flow of the large current can be both reduced in comparison with the case of 105 µm. Also, when a copper foil with a thickness of 200 µm is patterned by etching, there may occur a problem that the pattern pitch is increased and small chip resistors and capacitors cannot be mounted. By setting the thickness of the wiring pattern to be not larger than 175 µm, those small chip parts can also be mounted.

Fig. 19 shows the detailed structure of a connecting area using a lead frame between the power module and the control module.

The power module 210 and the control module 220 are connected to each other by using a lead frame LF. The lead frame LF is formed of, e.g., a brass sheet with a thickness of 0.15 mm and is shaped to have bent portions in its intermediate region as shown. Because the metallic board MP is used as a substrate of the power module 210 as described above, the lead frame LF is used to prevent thermal stresses from being imposed on the electrically connected portion between the power module 210 and the control module 220. The power module 210 is connected to one end of the lead frame LF by soldering, and the control module 220 is connected to the other end of the lead frame LF by soldering. With such a structure, the signal line connection can be realized as stress-free connection.

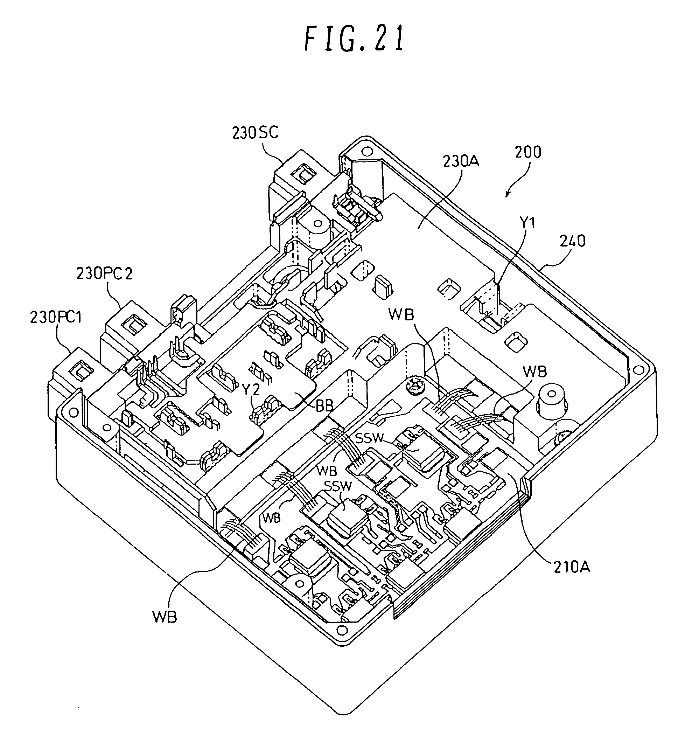

Fig. 21 shows another example of the structure of the control unit (inverter) used in the EPS system of the embodiment.

The structure of this example is basically similar to that shown in Figs. 14 and 15, and the circuit configuration is similar to that shown in Fig. 20.

In the state shown in Fig. 21, the power module 210 and a conductor module 230A are mounted in the casing 240, but the control module 220 is not yet mounted.

In this example, the shape of the conductor module 230A slightly differs from that of the conductor module 230 shown in Fig. 16. More specifically, the conductor module 230 shown in Fig. 16 is rectangular in plan view, whereas the conductor module 230A is L-shaped. Then, in an area indicated by Y1, respective terminals of electrolytic capacitors and ceramic capacitors are fixedly connected to the bus bars by welding. In other area indicated by Y2, as in Fig. 16, respective terminals of the relays, the normal filter, and the common filter are fixedly connected to the bus bars by TIG welding (arc welding).

According to the embodiment, as described above, the power module 210 and the conductor module 230 are connected to each other by welding, and the control module 220 and the power module 210 are connected to each other by soldering. In a section where a large current flows, therefore, higher reliability can be realized with the welding connection while avoiding a risk of melting possibly caused in the case of the soldering connection. Also, in the remaining section, manufacturability can be increased with the use of the soldering connection.

Further, since the wire bonding is employed for the connection between the power module 210 and the conductor module 230, stresses imposed on a large-current line can be relieved. Moreover, since a plurality of wires for the wire bonding are connected in parallel, a large current is allowed to flow between both the modules.

In addition, the power module 210 and the conductor module 230 are arranged on the same plane in opposed relation. Stated another way, the power module 210 is arranged in the casing 240 at one side, and the conductor module 230 is arranged in the casing 240 at the other side. As a result, the wire bonding operation can be easily performed.

The above embodiments of the invention may be combined in any way in part or as a whole.

## Claims

1. A motor (100) used in electric power steering to output electromotive forces for steering by employing, as a power supply, a lead storage battery (300, BA) in which a thin band-shaped positive plate (21), a thin band-shaped negative plate (20), and a band-shaped separator (22) interposed between said positive and negative plates (21, 20) are wound to form a plate group and said plate group is immersed in an electrolyte, and by receiving multi-phase AC power supplied from a power converter (200) for converting DC power obtained from said power supply to multi-phase AC power, said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of turns by wires,
said plurality of phase windings having wire ends which are projected axially outward from one axial end of said stator core (112) and are electrically connected by connecting members per phase,
said connecting members being formed of plate-shaped conductors (116) which are joined to the wire ends of said plurality of phase windings for electrical connection of said plurality of phase windings per phase, and
said stator coils (114) being electrically connected to a cable (162) for introducing the multi-phase AC power to said stator coils (114), whereby the multi-phase AC power introduced through said cable (162) is supplied to the corresponding phase windings of said stator coils (114).

2. The motor (100) used in electric power steering according to Claim 1, wherein said stator coils (114) are constituted by electrically connecting a plurality of phase winding groups in delta connection, which are obtained by electrically connecting said plurality of phase windings per phase.

3. A motor (100) used in electric power steering for outputting electromotive forces for steering by employing, as a power supply, a lead storage battery (300, BA) in which a thin band-shaped positive plate (21), a thin band-shaped negative plate (20), and a band-shaped separator (22) interposed between said positive and negative plates (21, 20) are wound to form a plate group and said plate group is immersed in an electrolyte, and by receiving multi-phase AC power supplied from a power converter (200) for converting DC power obtained from said power supply to multi-phase AC power, said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires, and
said stator coils (114) being constituted by electrically connecting a plurality of phase winding groups in delta connection, which are obtained by electrically connecting said plurality of phase windings per phase.

4. A motor (100) used in electric power steering to output electromotive forces for the steering by employing, as a power supply, a lead storage battery (300, BA) in which an area of a positive plate (21) constituting a spiral plate group immersed in an electrolyte is 1500 - 15000 cm² and a positive plate area per unit volume is 1700 - 17000 cm²/dm³ when maximum outer dimensions of said battery (300, BA) are estimated on an assumption of said battery (300, BA) being parallelepiped, and by receiving multi-phase AC power supplied from a power converter (200) for converting DC power obtained from said power supply to multi-phase AC power, said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said plurality of phase windings having wire ends which are projected axially outward from one axial end of said stator core (112) and are electrically connected by connecting members per phase,
said connecting members being formed of plate-shaped conductors (116) which are joined to the wire ends of said plurality of phase windings for electrical connection of said plurality of phase windings per phase, and
said stator coils (114) being electrically connected to a cable (162) for introducing the multi-phase AC power to said stator coils (114), whereby the multi-phase AC power introduced through said cable (162) is supplied to the corresponding phase windings of said stator coils (114).

5. The motor (100) used in electric power steering according to Claim 4, wherein said stator coils (114) are constituted by electrically connecting a plurality of phase winding groups in delta connection, which are obtained by electrically connecting said plurality of phase windings per phase.

6. A motor .(100) used in electric power steering to output electromotive forces for the steering by employing, as a power supply, a lead storage battery (300, BA) in which an area of a positive plate (21) constituting a spiral plate group immersed in an electrolyte is 1500 - 15000 cm² and a positive plate area per unit volume is 1700 - 17000 cm²/dm³ when maximum outer dimensions of said battery are estimated on an assumption of said battery (300, BA) being parallelepiped, and by receiving multi-phase AC power supplied from a power converter (200) for converting DC power obtained from said power supply to multi-phase AC power, said motor (100) comprising:
a stator (110); and
a rotor (130) disposed in opposed relation to said stator with a gap left therebetween,
said stator (110) comprising:
a stator core (112); and
multi-phase stator coils (114) assembled in said stator core (112),
said stator coils (114) being made up of a plurality of phase windings formed by winding a plurality of wires; and
said stator coils (114) being constituted by electrically connecting a plurality of phase winding groups in delta connection, which are obtained by electrically connecting said plurality of phase windings per phase.

7. A motor (100) used in electric power steering to output electromotive forces for the steering by employing, as a power supply, a lead storage battery (300, BA) which includes a spiral plate group immersed in an electrolyte and is capable of outputting a voltage larger than 12 V even when a current of at least 100 A is momentarily outputted, and by receiving multi-phase AC power supplied from a power converter (200) for converting DC power obtained from said power supply to multi-phase AC power, said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said plurality of phase windings having wire ends which are projected axially outward from one axial end of said stator core (112) and are electrically connected by connecting members per phase,
said connecting members being formed of plate-shaped conductors (116) which are joined to the wire ends of said plurality of phase windings for electrical connection of said plurality of phase windings per phase, and,
said stator coils (114) being electrically connected to a cable (162) for introducing the multi-phase AC power to said stator coils (114), whereby the multi-phase AC power introduced through said cable (162) is supplied to the corresponding phase windings of said stator coils (114).

8. The motor (100) used in electric power steering according to Claim 7, wherein said stator coils (114) are constituted by electrically connecting a plurality of phase winding groups in delta connection, which are obtained by electrically connecting said plurality of phase windings per phase.

9. A motor (100) used in electric power steering to output electromotive forces for the steering by employing, as a power supply, a lead storage battery (300, BA) which includes a spiral plate group immersed in an electrolyte and is capable of outputting a voltage larger than 12 V even when a current of at least 100 A is momentarily outputted, and by receiving multi-phase AC power supplied from a power converter (200) for converting DC power obtained from said power supply to multi-phase AC power, said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires, and
said stator coils (114) being constituted by electrically connecting a plurality of phase winding groups in delta connection, which are obtained by electrically connecting said plurality of phase windings per phase.

10. An inverter (200) used in electric power steering including a motor (100) to output electromotive forces for the steering by employing, as a power supply, a lead storage battery (300, BA) in which a thin band-shaped positive plate (21), a thin band-shaped negative plate (20), and a band-shaped separator (22) interposed between said positive and negative plates (21, 20) are wound to form a plate group and said plate group is immersed in an electrolyte, said inverter (200) converting DC power obtained from said power supply to multi-phase AC power and outputting the multi-phase AC power to said motor (100), thereby driving said motor (100), said inverter (200) comprising:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

11. An inverter (200) used in electric power steering including a motor (100) to output electromotive forces for the steering by employing, as a power supply, a lead storage battery (300, BA) in which an area of a positive plate (21) constituting a spiral plate group immersed in an electrolyte is 1500 - 15000 cm² and a positive plate area per unit volume is 1700 - 17000 cm²/dm³ when maximum outer dimensions of said battery (300, BA) are estimated on an assumption of said battery (300, BA) being parallelepiped, said inverter (200) converting DC power obtained from said power supply to multi-phase AC power and outputting the multi-phase AC power to said motor (100), thereby driving said motor (100), said inverter (200) comprising:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

12. An inverter (200) used in electric power steering including a motor (100) to output electromotive forces for the steering by employing, as a power supply, a lead storage battery (300, BA) which includes a spiral plate group immersed in an electrolyte and is capable of outputting a voltage larger than 12 V even when a current of at least 100 A is momentarily outputted, the inverter (200) converting DC power obtained from said power supply to multi-phase AC power and outputting the multi-phase AC power to said motor (100), thereby driving said motor (100), said inverter (200) comprising:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

13. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said plurality of phase windings having wire ends which are projected axially outward from one axial end of said stator core (112) and are electrically connected by connecting members per phase,
said connecting members being formed of plate-shaped conductors (116) which are joined to the wire ends of said plurality of phase windings for electrical connection of said plurality of phase windings per phase,
said stator coils (114) being electrically connected to a cable (162) for introducing the multi-phase AC power to said stator coils, whereby the multi-phase AC power introduced through said cable (162) is supplied to the corresponding phase windings of said stator coils (114),
said DC power supply being a lead storage battery (300, BA),
said lead storage battery (300, BA) including a single cell (40, 50) in which a plate group is immersed in an electrolyte, and
said plate group being wound into a spiral shape and comprising:
a positive plate (21) being in the form of a band-shaped thin plate;
a negative plate (20) being in the form of a band-shaped thin plate; and
a band-shaped separator (22) interposed between said positive and negative plates (21, 20).

14. The electric power steering system according to Claim 13, wherein said stator coils (114) are constituted by electrically connecting a plurality of phase winding groups in delta connection, which are obtained by electrically connecting said plurality of phase windings per phase.

15. The electric power steering system according to Claim 13, wherein said inverter (200) comprises:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

16. The electric power steering system according to Claim 15, wherein said stator coils (114) are constituted by electrically connecting a plurality of phase winding groups in delta connection, which are obtained by electrically connecting said plurality of phase windings per phase.

17. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said stator coils (114) being constituted by electrically connecting a plurality of phase winding groups in delta connection, which are obtained by electrically connecting said plurality of phase windings per phase,
said DC power supply being a lead storage battery (300, BA),
said lead storage battery (300, BA) including a single cell (40, 50) in which a plate group is immersed in an electrolyte, and
said plate group being wound into a spiral shape and comprising:
a positive plate (21) being in the form of a band-shaped thin plate;
a negative plate (20) being in the form of a band-shaped thin plate; and
a band-shaped separator (22) interposed between said positive and negative plates (21, 20).

18. The electric power steering system according to Claim 17, wherein said inverter (200) comprises:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

19. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said plurality of phase windings having wire ends which are projected axially outward from one axial end of said stator core (112) and are electrically connected by connecting members per phase,
said connecting members being formed of plate-shaped conductors (116) which are joined to the wire ends of said plurality of phase windings for electrical connection of said plurality of phase windings per phase,
said stator coils (114) being electrically connected to a cable (162) for introducing the multi-phase AC power to said stator coils (114), whereby the multi-phase AC power introduced through said cable (162) is supplied to the corresponding phase windings of said stator coils (114),
said DC power supply being a lead storage battery (300, BA),
said lead storage battery (300, BA) including a single cell (40, 50) in which a plate group is immersed in an electrolyte,
said plate group being wound into a spiral shape and constructed such that an area of a positive plate (21) constituting said plate group is 1500 - 15000 cm², and
a positive plate area per unit volume is 1700 - 17000 cm²/dm³ when maximum outer dimensions of said battery are estimated on an assumption of said battery being parallelepiped.

20. The electric power steering system according to Claim 19, wherein said stator coils (114) are constituted by electrically connecting a plurality of phase winding groups in delta connection, which are obtained by electrically connecting said plurality of phase windings per phase.

21. The electric power steering system according to Claim 19, wherein said inverter (200) comprises:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

22. The electric power steering system according to Claim 21, wherein said stator coils (114) are constituted by electrically connecting a plurality of phase winding groups in delta connection, which are obtained by electrically connecting said plurality of phase windings per phase.

23. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said stator coils (114) being constituted by electrically connecting a plurality of phase winding groups in delta connection, which are obtained by electrically connecting said plurality of phase windings per phase,
said DC power supply being a lead storage battery (300, BA),
said lead storage battery (300, BA) including a single cell (40, 50) in which a plate group is immersed in an electrolyte,
said plate group being wound into a spiral shape and constructed such that an area of a positive plate (21) constituting said plate group is 1500 - 15000 cm², and
a positive plate area per unit volume is 1700 - 17000 cm²/dm³ when maximum outer dimensions of said battery are estimated on an assumption of said battery being parallelepiped.

24. The electric power steering system according to Claim 23, wherein said inverter (200) comprises:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

25. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering device,
said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said plurality of phase windings having wire ends which are projected axially outward from one axial end of said stator core (112) and are electrically connected by connecting members per phase,
said connecting members being formed of plate-shaped conductors (116) which are joined to the wire ends of said plurality of phase windings for electrical connection of said plurality of phase windings per phase,
said stator coils (114) being electrically connected to a cable (162) for introducing the multi-phase AC power to said stator coils (114), whereby the multi-phase AC power introduced through said cable (162) is supplied to the corresponding phase windings of said stator coils (114),
said DC power supply being a lead storage battery (300, BA) which is constructed to be capable of outputting a voltage larger than 12 V even when a current of at least 100 A is momentarily outputted,
said lead storage battery (300, BA) including a single cell (40, 50) in which a plate group is immersed in an electrolyte, and
said plate group being wound into a spiral shape.

26. The electric power steering system according to Claim 25, wherein said stator coils (114) are constituted by electrically connecting a plurality of phase winding groups in delta connection, which are obtained by electrically connecting said plurality of phase windings per phase.

27. The electric power steering system according to Claim 25, wherein said inverter (200) comprises:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

28. The electric power steering system according to Claim 27, wherein said stator coils (114) are constituted by electrically connecting a plurality of phase winding groups in delta connection, which are obtained by electrically connecting said plurality of phase windings per phase.

29. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering device,
said motor (100) comprising:
a stator (110); and
a rotor (130) disposed in opposed relation to said stator (110) with a gap left therebetween,
said stator (110) comprising:
a stator core (112); and
multi-phase stator coils (114) assembled in said stator core (112),
said stator coils (114) being made up of a plurality of phase windings formed by winding a plurality of wires,
said stator coils (114) being constituted by electrically connecting a plurality of phase winding groups in delta connection, which are obtained by electrically connecting said plurality of phase windings per phase,
said DC power supply being a lead storage battery (300, BA) which is constructed to be capable of outputting a voltage larger than 12 V even when a current of at least 100 A is momentarily outputted,
said lead storage battery (300, BA) including a single cell (40, 50) in which a plate group is immersed in an electrolyte, and
said plate group being wound into a spiral shape.

30. The electric power steering system according to Claim 29, wherein said inverter (200) comprises:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B), and
said terminals being joined to said plate-shaped conductor (230B) by welding for electrical connection to said plate-shaped conductor (230B).

31. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said inverter (200) comprising:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B),
said terminals being joined to said plate-shaped conductor (230B) by welding for electrical connection to said plate-shaped conductor (230B),
said DC power supply being a lead storage battery (300, BA),
said lead storage battery (300, BA) including a single cell (40, 50) in which a plate group is immersed in an electrolyte, and
said plate group being wound into a spiral shape and comprising:
a positive plate (21) being in the form of a band-shaped thin plate;
a negative plate (20) being in the form of a band-shaped thin plate; and
a band-shaped separator (22) interposed between said positive and negative plates (21, 20).

32. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said inverter (200) comprising:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B),
said terminals being joined to said plate-shaped conductor (230B) by welding for electrical connection to said plate-shaped conductor (230B),
said DC power supply being a lead storage battery (300, BA),
said lead storage battery (300, BA) including a single cell (40, 50) in which a plate group is immersed in an electrolyte, and
said plate group being wound into a spiral shape and constructed such that an area of a positive plate (21) constituting said spiral plate group is 1500 - 15000 cm², and
a positive plate area per unit volume is 1700 - 17000 cm²/dm³ when maximum outer dimensions of said battery are estimated on an assumption of said battery being parallelepiped.

33. An electric power steering system comprising:
a DC power supply;
an inverter (200) for converting DC power supplied from said DC power supply to multi-phase AC power; and
a motor (100) for receiving the multi-phase AC power supplied from said inverter (200) and outputting steering electromotive forces to a steering apparatus,
said inverter (200) comprising:
a power module (210) including semiconductor switching devices (SSW);
a control module (220) electrically connected to said power module (210); and
a conductor module (230) electrically connected to said power module (210);
said power module (210) including a conversion circuit made up of said semiconductor switching devices (SSW),
said power module (210) converting the DC power supplied from the power supply side to multi-phase AC power by said conversion circuit and outputting the multi-phase AC power to the motor side,
said control module (220) supplying control signals for operating said semiconductor switching devices (SSW) to said power module (210), thereby controlling operation of said conversion circuit,
said conductor module (230) comprising:
a plate-shaped conductor (230B) electrically connected to said conversion circuit; and
circuit parts (230P) electrically connected to said plate-shaped conductor (230B),
said plate-shaped conductor (230B) forming a circuit for introducing the DC power supplied from the power supply side to said conversion circuit,
said circuit parts (230P) including at least a filter and a capacitor (CC),
said circuit parts (230P) including said filter and said capacitor (CC) being provided with terminals for connection to said plate-shaped conductor (230B),
said terminals being joined to said plate-shaped conductor (230B) by welding for electrical connection to said plate-shaped conductor (230B),
said DC power supply being a lead storage battery (300, BA) which is constructed to be capable of outputting a voltage larger than 12 V even when a current of at least 100 A is momentarily outputted,
said lead storage battery (300, BA) including a single cell (40, 50) in which a plate group is immersed in an electrolyte, and
said plate group being wound into a spiral shape.
